# EUROPEAN PATENT APPLICATION

(11) **EP 4 640 930 A1**
(43) Date of publication of application: **29.10.2025**
(21) Application number: 23907104.6
(22) Date of filing: 20.12.2023
(51) Int. Cl.: C30B 29/38, C30B 25/20

(54) **GAN SUBSTRATE**

(30) Priority: 21.12.2022 JP 2022204832; 21.12.2022 JP 2022204833
(71) Applicant: Mitsubishi Chemical Corporation, Tokyo 100-8251 (JP)
(72) Inventor: ISO Kenji, Tokyo 100-8251 (JP); HIROSAWA Takuya, Tokyo 100-8251 (JP)
(74) Representative: Hoffmann Eitle
(86) International application number: PCT/JP2023/045780
(87) International publication number: WO 2024/135744

(57) **Abstract**

The present invention relates to a GaN substrate including a main surface 1 inclined by 0° to 10° from a (0001) crystal plane which is a Ga-polar plane, and including a Si-doped GaN layer on at least a surface of the main surface 1, in which the Si-doped GaN layer has a Si concentration of 1 × 10¹⁸ atoms/cm³ or more, and a total of bottom areas of recessed defects on a surface of the Si-doped GaN layer is 15% or less of an area of the entire surface of the Si-doped GaN layer.

## Description

### TECHNICAL FIELD

The present invention relates to a gallium nitride (GaN) substrate.

### BACKGROUND ART

A substrate used for an InGaN-based laser diode (LD) that is currently commercially produced is a conductive GaN substrate having a relatively high carrier concentration. In recent years, research and development of vertical GaN power devices using such a conductive GaN substrate have been actively conducted.

Among GaN substrates used for laser diodes and vertical GaN power devices, in an n-type GaN substrate, the entire substrate is formed as a doped layer doped with an n-type donor, or a doped layer is provided in a part of a layer structure of the substrate, thereby forming a conductive GaN substrate. Resistance reduction of an n-type GaN substrate is required, and many attempts have been made to increase a donor doping concentration of a doped layer. When a device is produced, a metal for a negative electrode is placed on an n-type GaN substrate. The higher the donor concentration is, the better the ohmic property between the metal and a semiconductor is. Therefore, an n-type GaN substrate having a high carrier concentration has been desired for a long time.

However, when an attempt is made to obtain an n-type GaN substrate having a high carrier concentration, for example, by a Ge-doped layer employing Ge as a donor, pits are generated.

Therefore, Non-Patent Literature 1 discloses a GaN substrate having a Si-doped GaN layer adopting Si as a donor and doped with Si at a high concentration.

### CITATION LIST

### NON-PATENT LITERATURE

Non Patent Literature 1: M Iwinska et al., "Homoepitaxial growth of HVPE-GaN doped with Si", Journal of Crystal Growth, Vol. 456, p. 91-96, 2016

### SUMMARY OF INVENTION

### TECHNICAL PROBLEM

However, when doping is performed with Si at a high concentration on the order of 10¹⁸ atoms/cm³ or more, cissing occurs. The term cissing refers to a SiNx film formed on a surface of a GaN crystal, and occurs more as doping is performed with Si at a higher concentration.

Since an epitaxial growth of GaN is inhibited in a part where cissing occurs, a recessed portion is generated on a surface of the obtained GaN substrate. The part where the recessed portion is formed cannot be used as a device, and therefore, the yield of device production deteriorates.

Further, an activation rate of Si is about 100% in principle because an ionization energy of Si is sufficiently small so that Si is ionized at room temperature. However, it has been found that when doping is performed with Si at a high concentration as in Non-Patent Literature 1, Si, which is a doped carrier impurity, does not function as an original carrier, and the activation rate tends to decrease. The cause is considered, for example, that Si atoms do not enter Ga sites, which is an original position, but enter such as an interstitial site or an anti-site (N site).

As described above, there is a trade-off relationship between an increase in the Si concentration and a yield of device production. In addition, even when doping is performed with Si at a high concentration, it is difficult to perform resistance reduction corresponding to the concentration, and a further improvement is desired.

Therefore, an object of an aspect A of the present invention is to provide a GaN substrate capable of achieving both resistance reduction and improvement in device yield deterioration. Another object of the present invention is to provide a GaN substrate in which resistance reduction corresponding to a concentration of doped Si is achieved.

In addition, it has been found that when doping is performed with Si at a high concentration on the order of 10¹⁸ atoms/cm³ or more, the conductivity at an end portion of the GaN substrate decreases, and the resistance on a negative electrode side of the semiconductor device produced using this GaN substrate increases.

Therefore, an object of an aspect B of the present invention is to provide a GaN substrate in which resistance reduction corresponding to the concentration of doped Si is uniformly achieved over the entire substrate.

### SOLUTION TO PROBLEM

As a result of intensive studies by the present inventors, it has been found that by narrowing a terrace width when epitaxially growing a Si-doped GaN crystal, the occurrence of cissing is prevented, and further, Si atoms are easily and appropriately incorporated into a kink site. Accordingly, the present inventors have found that a GaN substrate that solves the above problems can be obtained, and have completed the aspect A of the present invention.

In addition, as a result of intensive studies by the present inventors, it has been found that the resistance is uneven because doping with Si is not uniformly performed, and in particular, Si cannot be well incorporated in an end portion of the GaN substrate. In contrast, as a result of further studies by the present inventors, it has been found that a GaN substrate that solves the above problems can be obtained by using a vapor phase growth method for forming a Si-doped GaN layer, narrowing a terrace width at that time, and setting a distance between an ejection nozzle of GaCl gas as a raw material and a substrate surface to be within a specific range in a reactor, and have completed the aspect B of the present invention.

That is, the gist of the present invention including the aspect A and the aspect B is as follows.
[1] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a Si concentration of 1 × 10¹⁸ atoms/cm³ or more, and
   a total of bottom areas of recessed defects on a surface of the Si-doped GaN layer is 15% or less of an area of the entire surface of the Si-doped GaN layer.
[2] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a Si concentration of 1 × 10¹⁸ atoms/cm³ or more, and
   a value represented by {(b/a) × 100} (%) is 90% or more, in which a (atoms/cm³) represents a Si concentration of the Si-doped GaN layer, and b (atoms/cm³) represents a carrier concentration of the Si-doped GaN layer.
[3] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a Si concentration of 1 × 10¹⁸ atoms/cm³ or more, and
   a value represented by [{(α - β)/α} × 100] (%) is 10% or less, in which α (atoms/cm³) represents a maximum value of the Si concentration of a surface of the Si-doped GaN layer, and β (atoms/cm³) represents a minimum value of the Si concentration of a surface of the Si-doped GaN layer.
[4] The GaN substrate according to any one of [1] to [3], in which the Si-doped GaN layer has a thickness of 50 µm or more.
[5] The GaN substrate according to any one of [1] to [4], in which a total of bottom areas of recessed portions each having a depth of 5 µm or more on the surface of the Si-doped GaN layer is 15% or less of an area of the entire surface of the Si-doped GaN layer.
[6] The GaN substrate according to any one of [1] to [5], in which one or more 5 mm × 5 mm square lattices without a recessed defect are present on the surface of the Si-doped GaN layer.
[7] The GaN substrate according to any one of [1] to [6], in which one or more 5 mm × 5 mm square lattices without a recessed portion having a depth of 5 µm or more are present on the surface of the Si-doped GaN layer.
[8] The GaN substrate according to any one of [1] to [7], in which the Si-doped GaN layer has a specific resistance at 300 K of 1 × 10⁻² Ωcm or less.
[9] The GaN substrate according to any one of [1] to [8], in which the Si-doped GaN layer has a specific resistance at 300 K of 8 × 10⁻³ Ωcm or less.
[10] The GaN substrate according to any one of [1] to [9], in which the Si-doped GaN layer has a specific resistance at 300 K of 4 × 10⁻³ Ωcm or less.
[11] The GaN substrate according to any one of [1] to [10], in which the Si-doped GaN layer has a Si concentration of 5 × 10¹⁸ atoms/cm³ or more.
[12] The GaN substrate according to any one of [1] to [11], in which the Si-doped GaN layer has a Si concentration of 9 × 10¹⁸ atoms/cm³ or more.
[13] The GaN substrate according to any one of [1] to [12], in which the GaN substrate is a wafer, and the wafer has a diameter of 50 mm or more.
[14] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a thickness of 50 µm or more, and
   a total of bottom areas of recessed portions each having a depth of 5 µm or more on a surface of the Si-doped GaN layer is 15% or less of an area of the entire surface of the Si-doped GaN layer.
[15] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a thickness of 50 µm or more, and
   a value represented by {(b/a) × 100} (%) is 90% or more, in which a (atoms/cm³) represents a Si concentration of the Si-doped GaN layer, and b (atoms/cm³) represents a carrier concentration of the Si-doped GaN layer.
[16] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a Si concentration of 1 × 10¹⁸ atoms/cm³ or more,
   the Si-doped GaN layer has a thickness of 50 µm or more, and
   a value represented by [{(α - β)/α} × 100] (%) is 10% or less, in which α (atoms/cm³) represents a maximum value of the Si concentration of a surface of the Si-doped GaN layer, and β (atoms/cm³) represents a minimum value of the Si concentration of a surface of the Si-doped GaN layer.

An aspect of the aspect A of the present invention is as follows.
[1] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a thickness of 50 µm or more, and
   a total of bottom areas of recessed portions each having a depth of 5 µm or more on a surface of the Si-doped GaN layer is 15% or less of an area of the entire surface of the Si-doped GaN layer.
[2] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a thickness of 50 µm or more, and
   a value represented by {(b/a) × 100} (%) is 90% or more, in which a (atoms/cm³) represents a Si concentration of the Si-doped GaN layer, and b (atoms/cm³) represents a carrier concentration of the Si-doped GaN layer.
[3] The GaN substrate according to [1] or [2], in which the Si-doped GaN layer has a Si concentration of 1 × 10¹⁸ atoms/cm³ or more.
[4] The GaN substrate according to any one of [1] to [3], in which one or more 5 mm × 5 mm square lattices without a recessed portion having a depth of 5 µm or more are present on the surface of the Si-doped GaN layer.
[5] The GaN substrate according to any one of [1] to [4], in which the Si-doped GaN layer has a specific resistance at 300 K of 1 × 10⁻² Ωcm or less.
[6] The GaN substrate according to any one of [1] to [5], in which the Si-doped GaN layer has a specific resistance at 300 K of 8 × 10⁻³ Ωcm or less.
[7] The GaN substrate according to any one of [1] to [6], in which the Si-doped GaN layer has a specific resistance at 300 K of 4 × 10⁻³ Ωcm or less.
[8] The GaN substrate according to any one of [1] to [7], in which the Si-doped GaN layer has a Si concentration of 5 × 10¹⁸ atoms/cm³ or more.
[9] The GaN substrate according to any one of [1] to [8], in which the Si-doped GaN layer has a Si concentration of 9 × 10¹⁸ atoms/cm³ or more.
[10] The GaN substrate according to any one of [1] to [9], in which the GaN substrate is a wafer, and the wafer has a diameter of 50 mm or more.

An aspect of the aspect B of the present invention is as follows.
[1] A GaN substrate including:
   a main surface 1 inclined by 0° to 10° from a (0001) crystal plane which is a Ga-polar plane; and
   a Si-doped GaN layer on at least a surface of the main surface 1,
   in which the Si-doped GaN layer has a Si concentration of 1 × 10¹⁸ atoms/cm³ or more,
   the Si-doped GaN layer has a thickness of 50 µm or more, and
   a value represented by [{(α - β)/α} × 100] (%) is 10% or less, in which α (atoms/cm³) represents a maximum value of the Si concentration of a surface of the Si-doped GaN layer, and β (atoms/cm³) represents a minimum value of the Si concentration of a surface of the Si-doped GaN layer.
[2] The GaN substrate according to [1], in which the GaN substrate is a wafer, and the wafer has a diameter of 50 mm or more.
[3] The GaN substrate according to [1] or [2], in which the Si-doped GaN layer has a specific resistance at 300 K of 1 × 10⁻² Ωcm or less.
[4] The GaN substrate according to any one of [1] to [3], in which the Si-doped GaN layer has a specific resistance at 300 K of 8 × 10⁻³ Ωcm or less.
[5] The GaN substrate according to any one of [1] to [4], in which the Si-doped GaN layer has a specific resistance at 300 K of 4 × 10⁻³ Ωcm or less.
[6] The GaN substrate according to any one of [1] to [5], in which the Si-doped GaN layer has a Si concentration of 9 × 10¹⁸ atoms/cm³ or more.

### ADVANTAGEOUS EFFECTS OF INVENTION

According to the aspect A of the present invention, it is possible to provide a GaN substrate in which device yield deterioration is reduced while achieving resistance reduction. In addition, it is also possible to provide a GaN substrate in which resistance reduction corresponding to the concentration of doped Si is achieved.

Therefore, the GaN substrate is very suitable as an n-type conductive GaN substrate used for a laser diode or a vertical GaN power device.

Further, according to the aspect B of the present invention, it is possible to provide a GaN substrate in which resistance reduction corresponding to the concentration of doped Si is uniformly achieved in the entire substrate.

Therefore, the GaN substrate is very suitable as an n-type conductive GaN substrate used for a laser diode or a vertical GaN power device.

### BRIEF DESCRIPTION OF DRAWINGS

[FIG. 1] FIG. 1 is a schematic cross-sectional view illustrating an aspect of a GaN substrate according to first to fourth embodiments.
[FIG. 2] FIG. 2 is a view illustrating an off-angle provided in a base crystal used in a method of forming a Si-doped GaN layer. FIG. 2 (a) illustrates a state of being cut out obliquely with respect to a (0001) surface of the base crystal, FIG. 2 (b) illustrates the base crystal after being cut out, and FIG. 2 (c) illustrates an enlarged view of a part surrounded by a circle mark in FIG. 2 (b).
[FIG. 3] FIG. 3 is a view illustrating a case where the off-angle of the (0001) surface of the base crystal is increased as compared with FIG. 2 (c).
[FIG. 4] FIG. 4 is a process cross-sectional view illustrating a method for producing a first c-plane GaN wafer used for producing the GaN substrate according to the first to fourth embodiments. FIG. 4 (a) illustrates a seed wafer, FIG. 4 (b) illustrates a state where a first thick GaN film has grown on the seed wafer, and FIG. 4 (c) illustrates a state where a plurality of first c-plane GaN wafers are obtained by thinning the obtained first thick GaN film.
[FIG. 5] FIG. 5 is a process cross-sectional view illustrating a method for producing a second c-plane GaN wafer used for producing the GaN substrate according to the first to fourth embodiments. FIG. 5 (a) illustrates a state of the first c-plane GaN wafer, FIG. 5 (b) illustrates a state where a second thick GaN film has grown on the first c-plane GaN wafer, and FIG. 5 (c) illustrates a state where the second c-plane GaN wafer is obtained by thinning the obtained second thick GaN film.
[FIG. 6] FIG. 6 is a process cross-sectional view illustrating a method for producing a GaN substrate according to the first to fourth embodiments. FIG. 6 (a) illustrates a state of the second c-plane GaN wafer, and FIG. 6 (b) illustrates a state where a Si-doped GaN layer has grown on the second c-plane GaN wafer.
[FIG. 7] FIG. 7 is a schematic diagram illustrating a basic configuration of an HVPE device.
[FIG. 8] FIG. 8 is a fluorescence image of a surface of the GaN substrate obtained in Example 1-1.
[FIG. 9] FIG. 9 is a fluorescence image of a surface of the GaN substrate obtained in Comparative Example 1-1.

### DESCRIPTION OF EMBODIMENTS

Hereinafter, embodiments of the present invention are specifically described, but the present invention is not limited to the following embodiments, and the present invention can be implemented with various modifications within the scope of a gist thereof.

In addition, "to" indicating a numerical range is used to include the numerical values described before and after it as a lower limit value and an upper limit value.

### [GaN Substrate (1)]

In an aspect of a GaN substrate according to a first embodiment, the GaN substrate has a main surface 1 inclined by 0° to 10° from a (0001) crystal plane which is a Ga-polar plane, and has a Si-doped GaN layer on at least a surface of the main surface 1, in which the Si-doped GaN layer has a Si concentration of 1 × 10¹⁸ atoms/cm³ or more. Further, a total bottom area of recessed portions on a surface of the Si-doped GaN layer is 15% or less of an area of the entire surface of the Si-doped GaN layer.

In another aspect of the GaN substrate according to the first embodiment, the GaN substrate has a main surface 1 inclined by 0° to 10° from a (0001) crystal plane which is a Ga-polar plane and has a Si-doped GaN layer on at least a surface of the main surface 1, in which the Si-doped GaN layer has a thickness of 50 µm or more. Further, a total of bottom areas of recessed portions each having a depth of 5 µm or more on the surface of the Si-doped GaN layer is 15% or less of an area of the entire surface of the Si-doped GaN layer.

In an aspect of a GaN substrate according to a second embodiment, the GaN substrate has a main surface 1 inclined by 0° to 10° from a (0001) crystal plane which is a Ga-polar plane, and has a Si-doped GaN layer on a surface of at least the main surface 1, in which the Si-doped GaN layer has a Si concentration of 1 × 10¹⁸ atoms/cm³ or more. Further, a value represented by {(b/a) × 100} (%) is 90% or more, in which a (atoms/cm³) represents a Si concentration of the above Si-doped GaN layer, and b (atoms/cm³) represents a carrier concentration of the above Si-doped GaN layer.

In another aspect of the GaN substrate according to the second embodiment, the GaN substrate has a main surface 1 inclined by 0° to 10° from a (0001) crystal plane which is a Ga-polar plane, and has a Si-doped GaN layer on at least a surface of the main surface 1, in which the Si-doped GaN layer has a thickness of 50 µm or more. Further, a value represented by {(b/a) × 100} (%) is 90% or more, in which a (atoms/cm³) represents a Si concentration of the above Si-doped GaN layer, and b (atoms/cm³) represents a carrier concentration of the above Si-doped GaN layer.

In both embodiments of the first embodiment and the second embodiment, the main surface 1 inclined from the (0001) crystal plane may be by 0° to 10°, and is preferably by 0° to 5°, and more preferably by 0° to 2.5°. A lower limit of the inclination is 0°, and the inclination may be 0.2° or more. An upper limit of the inclination is 10°, and the inclination is preferably 5° or less, more preferably 2.5° or less, may be 1.5° or less, or may be 1° or less.

In both embodiments of the first embodiment and the second embodiment, the GaN substrate has a Si-doped GaN layer on the surface of the main surface 1. In the present description, "has a Si-doped GaN layer on the surface of main surface 1" means that an outermost surface of the main surface 1 of the GaN substrate coincides with an outermost surface of the Si-doped GaN layer.

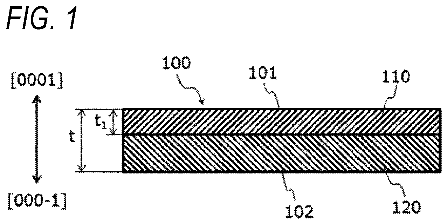

In both embodiments of the first embodiment and the second embodiment, as illustrated in FIG. 1, a GaN substrate 100 may be (0001)-oriented, and may have a GaN crystal layer 120 and a Si-doped GaN layer 110 on a (0001) surface 101, which is a Ga-polar plane side. After the Si-doped GaN layer 110 is formed, the GaN crystal layer 120 used as a base crystal may be removed to form the GaN substrate 110 including only the Si-doped GaN layer 110.

The (0001)-oriented GaN substrate refers to a substrate having a (0001) crystal plane, that is, a main surface parallel or substantially parallel to the c-plane, that is, a large-area plane, and is also referred to as a c-plane GaN substrate. Here, the expression "parallel or substantially parallel" means that the inclination from the (0001) crystal plane, which is the Ga-polar plane, is 0° to 10°.

The Si-doped GaN layer 110 in both embodiments means a layer obtained by substituting a part of Ga of a GaN crystal with Si. When the GaN substrate has the Si-doped GaN layer, the resistance of the substrate can be reduced, which is useful as a conductive substrate.

The Si concentration of the Si-doped GaN layer 110 is preferably 1 × 10¹⁸ atoms/cm³ or more. In this case, the resistance of the substrate can be further reduced, and the usefulness as a conductive substrate is increased. From the viewpoint of the resistance reduction, the Si concentration of the Si-doped GaN layer 110 is more preferably 2 × 10¹⁸ atoms/cm³ or more, still more preferably 5 × 10¹⁸ atoms/cm³ or more, yet still more preferably 7 × 10¹⁸ atoms/cm³ or more, and particularly preferably 9 × 10¹⁸ atoms/cm³ or more, and is preferably as high as possible. An upper limit of the Si concentration is not particularly limited, and the Si concentration is, for example, 1 × 10²¹ atoms/cm³ or less.

In the present description, a concentration of donor impurities such as Si (silicon) in the Si-doped GaN layer can be determined by secondary ion mass spectrometry (SIMS). The donor impurity concentration such as the Si concentration may vary along a c-axis direction, but an average of the donor impurity concentrations from a depth of 3 µm to a depth of 50 µm from the Si-doped GaN layer surface can be defined as the donor impurity concentration.

The higher the Si concentration in the Si-doped GaN layer 110 is, the more easily cissing occurs. As described above, the term cissing refers to a SiNx film formed on a surface of a GaN crystal, and is a silicon nitride film in which N atoms originally bonded to Ga atoms are bonded to Si atoms.

In a part where the cissing occurs, epitaxial growth of GaN is inhibited, and when the epitaxial growth is continued as it is, a recessed portion on a surface of the obtained GaN substrate is formed. The recessed portion on the surface may be referred to as a "recessed defect" in the present description. The presence of the recessed portion on the surface of the GaN substrate deteriorates the yield of device production using the GaN substrate.

In contrast, in the Si-doped GaN layer 110 according to the first embodiment, the occurrence of cissing is prevented. Therefore, the number of the recessed portions on the surface of the GaN substrate are reduced, and the resistance of the substrate can be reduced without deteriorating the yield of device production.

Details of a mechanism by which such a GaN substrate is obtained are not clear, but are considered as follows.

When a molecule containing a Si atom and a molecule such as NH₃ containing a N atom are in a gas phase state, the molecules hardly react to form silicon nitride. It is considered that cissing is formed by causing a reaction between the molecule containing a Si atom and a molecule such as NH₃ which meet by thermal motion or the like when the molecules are present in a state of being adsorbed together in the same terrace of the surface of the GaN crystal.

In contrast, it has been found in the present invention that the occurrence of cissing can be prevented by narrowing the terrace. It is considered that this is because the probability of cissing occurring due to an encounter between molecules such as NH₃ adsorbed on the terrace and the Si adatom can be reduced by shortening the time for the Si atoms adsorbed on the terrace, i.e., the Si adatoms, to reach the kink site located at a step end. As a result, even when the Si concentration is increased and the density of Si adatoms in the terrace is increased, the probability of encounter with the adsorbed N atoms is reduced. Then, the number of recessed portions on the surface of the Si-doped GaN layer accompanied by the occurrence of cissing is reduced, and a smooth surface can be obtained.

The recessed portion on the surface of the Si-doped GaN layer in the present description has the same meaning as a recessed defect as described above, and refers to a defect in which a crystal is not present in a recessed shape on the surface. The recessed portion may particularly refer to a portion having a depth of 5 µm or more.

In the first embodiment, the total of the bottom areas of the recessed defects with respect to the area of the entire surface of the Si-doped GaN layer is 15% or less, preferably 10% or less, more preferably 5% or less, still more preferably 1% or less, and particularly preferably 0.1% or less, and is preferably as low as possible, and may be 0%. It can be said that the smaller the total of the bottom areas of the recessed portions is, the less the occurrence of cissing is, and the deterioration in the yield of device production can be prevented.

In the first embodiment, the total of the bottom areas of the recessed portions having a depth of 5 µm or more with respect to the area of the entire surface of the Si-doped GaN layer is also preferably 15% or less, more preferably 10% or less, still more preferably 5% or less, yet still more preferably 1% or less, and particularly preferably 0.1% or less, and is preferably as low as possible, and may be 0%.

The presence of the recessed defects can be determined by observation with a microscope or the like, and the total of the bottom areas can also be calculated. In particular, the recessed portion having a depth of 5 µm or more can be distinguished by the difference in color when the surface of the Si-doped GaN layer is observed under irradiation with ultraviolet and a fluorescence image is obtained, regarding the total of the bottom areas of the recessed portions. The total of the bottom areas of all the recessed portions each having a depth of 5 µm or more can be determined from the fluorescence image using the difference in color. Therefore, the total of the bottom areas of the recessed portions each having a depth of 5 µm or more with respect to the area of the entire surface of the Si-doped GaN layer is further accurately calculated.

It was also found that the activation rate decreases as the Si concentration of the Si-doped GaN layer 110 increases. The activation rate means a ratio of impurities functioning as carriers to the doped carrier impurities which is present in the crystal. In the present description, a value represented by {(b/a) × 100} (%) can be as the activation rate, in which a (atoms/cm³) represents the Si concentration of the Si-doped GaN layer, and b (atoms/cm³) represents the carrier concentration of the Si-doped GaN layer.

As described above, an activation rate of Si is about 100% in principle because an ionization energy of Si is sufficiently small so that Si is ionized at room temperature. In contrast, it is considered that the Si atom does not enter the Ga site which is an original position, but enters, for example, an interstitial site or an anti-site (N site), causing the decrease in the activation rate.

In contrast, the Si-doped GaN layer 110 in the second embodiment can maintain a high activation rate even when the Si concentration is increased, and can achieve resistance reduction accompanied by an increase in the Si concentration.

The details are not clear, but are considered as follows.

The reason why the Si atom does not enter the Ga site which is an original position, but enters, for example, the interstitial site or the anti-site (N site) is considered to be that the terrace is wide and a movement distance until the Si atom is incorporated into the kink site is long.

In contrast, in the present invention, the activation rate has been improved by narrowing the terrace. This is considered that the distance for the Si atom to reach the kink site is shortened due to the narrow terrace, thereby the probability that the Si atom is incorporated into an appropriate kink site and can function as a dopant is increased. As a result, it is considered that even when the Si concentration is increased and the density of the Si adatom in the terrace is increased, Si atoms are incorporated into an appropriate kink site, so that a high activation rate is achieved, and a low resistivity corresponding to the concentration of Si can be achieved.

In the second embodiment, the value represented by {(b/a) × 100} (%) is 90% or more, preferably 95% or more, and more preferably 98% or more, and is preferably as high as possible, and is most preferably 100%, in which a (atoms/cm³) represents the Si concentration of the Si-doped GaN layer, and b (atoms/cm³) represents the carrier concentration of the Si-doped GaN layer.

It can be said that as the value represented above, that is, the activation rate is increased, the resistance corresponding to the concentration of doped Si can be reduced.

The recessed portion on the surface of the Si-doped GaN layer in the first embodiment and the activation rate in the second embodiment have been described above. However, the GaN substrate according to the first embodiment does not exclude the fact that the GaN substrate according to the first embodiment has a high activation rate in addition to the resistance reduction and the prevention of the deterioration in the yield of device production, and the fact that the GaN substrate according to the second embodiment can prevent the deterioration in the yield of device production in addition to the resistivity reduction corresponding to the Si concentration due to the high activation rate.

That is, in the first embodiment, the value represented by {(b/a) × 100} (%) is preferably 90% or more, more preferably 95% or more, and still more preferably 98% or more, and is preferably as high as possible, and most preferably 100%, in which a (atoms/cm³) represents the Si concentration of the Si-doped GaN layer, and b (atoms/cm³) represents the carrier concentration of the Si-doped GaN layer.

In the second embodiment, the total of the bottom areas of the recessed defects on the surface of the Si-doped GaN layer is preferably 15% or less, more preferably 10% or less, still more preferably 5% or less, yet still more preferably 1% or less, and particularly preferably 0.1% or less, of the area of the entire surface of the Si-doped GaN layer, and is preferably as low as possible, and may be 0%.

In the second embodiment, the total of the bottom areas of the recessed portions each having a depth of 5 µm or more on the surface of the Si-doped GaN layer is preferably 15% or less, more preferably 10% or less, still more preferably 5% or less, yet still more preferably 1% or less, and particularly preferably 0.1% or less, of the area of the entire surface of the Si-doped GaN layer, and is preferably as low as possible, and may be 0%.

In both embodiments, it is preferable that one or more 5 mm x 5 mm square lattices without recessed defects are present on the surface of the Si-doped GaN layer. It can be said that the presence of one or more such square lattices can reduce the occurrence of cissing in the GaN substrate and can prevent the deterioration in the yield of device production, and therefore, the presence of one or more such square lattices is highly useful as a GaN substrate used for device production.

From the same viewpoint, on the surface of the Si-doped GaN layer, it is more preferable that one or more 10 mm × 10 mm square lattices without recessed defects are present, it is particularly preferable that one or more 15 mm × 15 mm square lattices without recessed defects are present, and it is particularly preferable that one or more 25 mm × 25 mm square lattices without recessed defects are present. The presence of the square lattices can be confirmed by observing the surface of the GaN substrate with a microscope or the like.

In addition, in both embodiments, it is preferable that one or more 5 mm × 5 mm square lattices without a recessed portion having a depth of 5 µm or more are present on the surface of the Si-doped GaN layer. It can be said that the presence of one or more such square lattices can reduce the occurrence of cissing in the GaN substrate and can prevent the deterioration in the yield of device production, and therefore, the presence of one or more such square lattices is highly useful as a GaN substrate used for device production. From the same viewpoint, on the surface of the Si-doped GaN layer, it is more preferable that one or more 10 mm × 10 mm square lattices without a recessed portion having a depth of 5 µm or more are present, it is particularly preferable that one or more 15 mm × 15 mm square lattices without a recessed portion having a depth of 5 µm or more are present, and it is particularly preferable that one or more 25 mm × 25 mm square lattices without a recessed portion having a depth of 5 µm or more are present. The presence of the square lattices can be confirmed by observing a fluorescence image of the GaN substrate.

The recessed defect and the recessed portion having a depth of 5 µm or more do not limit the size of the GaN substrate. For example, when the GaN substrate is a wafer having a diameter of 45 mm or more, the recessed defect or the recessed portion having a depth of 5 µm or more can be applied as it is. However, when the GaN substrate is a square substrate having a minor axis of less than 5 mm, a wafer having a diameter of 7 mm or less, or the like, a 5 mm × 5 mm square lattice cannot be formed on the surface of the Si-doped GaN layer. Even in that case, when the requirements of the first embodiment and the second embodiment are satisfied, the above square substrate and wafer fall within the range of the GaN substrate according to the present invention.

In both embodiments, the thickness of the Si-doped GaN layer is preferably 50 µm or more, and more preferably 50 µm to 300 µm. Accordingly, even the Si-doped GaN layer alone has a self-supporting property, and even when the GaN substrate is formed of only the Si-doped GaN layer, the Si-doped GaN layer can serve as a substrate.

The thickness of the Si-doped GaN layer is preferably 50 µm or more, more preferably 80 µm or more, and still more preferably 100 µm or more. The upper limit of the thickness is not particularly limited, and the thickness is, for example, 300 µm or less, may be 200 µm or less, and may be 150 µm or less.

The thickness of the Si-doped GaN layer in the present description is the thickness of a layer having a Si concentration of 1 × 10¹⁸ atoms/cm³ or more, and can be measured by the above-described SIMS. When the thickness of the Si-doped GaN layer is not uniform, the smallest thickness may be in the above range.

In both embodiments, the Si-doped GaN layer may contain group 14 elements such as Ge (germanium) or group 16 elements such as O (oxygen) and S (sulfur) as donor impurities in addition to Si (silicon). A total concentration of the donor impurities other than Si is, for example, 10% or less of the Si concentration, may be 5% or less, may be 1% or less, or may be 0% of the Si concentration (not contained).

As described below, the GaN substrates according to both embodiments is preferably crystal-grown by, for example, a vapor phase growth method, and more preferably a hydride vapor phase epitaxy (HVPE) method.

The Si-doped GaN layer obtained by the above method may contain O (oxygen) at a concentration on the order of 10¹⁵ atoms/cm³ or more even when O is not intentionally added. That is, the Si-doped GaN layer may have an O (oxygen) concentration of 1 × 10¹⁵ atoms/cm³ or more.

On the other hand, donor impurities other than Si and O are contained in the Si-doped GaN layer at a non-negligible concentration only when the GaN substrate is intentionally doped with such donor impurities. Note that "intentionally doping" means, for example, a case where the element is added in the form of a simple substance or a compound as a raw material in order to dope the Si-doped GaN layer with the target element.

Therefore, unless the Si-doped GaN layer is intentionally doped with the donor impurities other than Si and O, the total donor impurity concentration of the Si-doped GaN layer may be considered to be equal to the sum of the Si concentration and the O concentration.

Whether the Si-doped GaN layer is doped with the donor impurities other than Si and O can be checked by an elemental analysis or the like.

From the viewpoint of crystallinity, the concentration of each of the donor impurities other than Si is preferably 1 × 10¹⁷ atoms/cm³ or less, more preferably 8 × 10¹⁶ atoms/cm³ or less, and still more preferably 5 × 10¹⁶ atoms/cm³ or less. In addition, for the same reason, the total concentration of the donor impurities other than Si is preferably 2 × 10¹⁷ atoms/cm³ or less, more preferably 8 × 10¹⁶ atoms/cm³ or less, and still more preferably 5 × 10¹⁶ atoms/cm³ or less.

The Si-doped GaN layer may contain elements other than Ga, N, and Si, which constitute the GaN crystal, and the group 14 element and the group 16 element atoms serving as other donor impurities. Other elements may be intentionally contained or unintentionally and inevitably contained, and examples thereof include H (hydrogen), C (carbon), Cl (chlorine), and the like. The total concentration of these other elements may be on the order of 10¹⁶ atoms/cm³ to 10¹⁷ atoms/cm³.

The full width at half maximum of a X-ray diffraction rocking curve of a (004) plane of the Si-doped GaN layer is preferably 50 arcsec or less. The rocking curve is a diffraction intensity distribution in the case where a direction of incident X-rays and a position of a detector are fixed and only a crystal as a sample is rotated in an X-ray diffraction measurement, and is one of indexes indicating crystal quality.

A smaller value of the full width at half maximum of the rocking curve means that the fewer crystal defects and the better crystal quality. The full width at half maximum is preferably 40 arcsec or less, more preferably 30 arcsec or less, and still more preferably 20 arcsec or less. The lower limit of the full width at half maximum is not particularly limited, and the full width at half maximum is generally 5 arcsec or more. The full width at half maximum in the present description has the same meaning as the half width in general. That is, the half width means a distance between positions indicating an intensity 1/2fₘₐₓ which is half the maximum intensity fₘₐₓ of a peak.

The full width at half maximum can be adjusted by a method of growing a GaN crystal layer in the Si-doped GaN layer (a vapor phase method, a liquid phase method, or the like), the crystal characteristics, crystal growth conditions, selection of a surface for growth, the content of impurities, and the like of a seed substrate used for growing a GaN crystal layer.

In both embodiments, the dislocation density on the surface of the Si-doped GaN layer is preferably 5 × 10⁶ cm⁻² or less. In this case, the device performance deterioration due to dislocation can be prevented. From the same viewpoint, the dislocation density on the surface of the Si-doped GaN layer is more preferably 2 × 10⁶ cm⁻² or less, and still more preferably 1 × 10⁶ cm⁻² or less.

The dislocation density of the Si-doped GaN layer is preferably equal to or higher than the dislocation density of the GaN crystal layer which is the base crystal layer, and more specifically, is preferably 0.5 times or more and less than 2 times the dislocation density of the GaN crystal layer which is the base crystal layer. The fact that both dislocation densities are the same or substantially the same means that no new dislocation is generated at an interface between the GaN crystal layer and the Si-doped GaN layer.

In both embodiments, the GaN crystal layer on which the Si-doped GaN layer is to be formed becomes a base crystal and is a layer in which GaN is epitaxially grown. The GaN crystal layer may have a specific resistance of less than 1 × 10⁵ Ωcm at room temperature, that is, may not be a layer of semi-insulating.

In both embodiments, the GaN crystal layer may unintentionally and inevitably contain Si, O, H, or the like as an element other than Ga and N. For example, the Si concentration may be 5 × 10¹⁷ atoms/cm³ or less. The O concentration may be 2 × 10¹⁷ atoms/cm³ or less. The H concentration may be 5 × 10¹⁶ atoms/cm³ or less. The concentration of each of elements other than Si, O, and H may be 5 × 10¹⁵ atoms/cm³ or less.

In both embodiments, when the GaN substrate is used for producing a nitride semiconductor device, the GaN crystal layer may be removed, and the Si-doped GaN layer may be used for a nitride semiconductor device chip. In such a mode of use, there is no particular requirement for electrical characteristics of the GaN crystal layer.

The Si-doped GaN layer in the GaN substrate may be formed directly on the c-plane of the GaN crystal layer or may be formed via a regrowth interface.

The regrowth interface means an interface generated when a crystal to be the Si-doped GaN layer is grown on the GaN crystal layer. The presence of the regrowth interface can be confirmed by, for example, observing a cross section of the GaN substrate wafer using a scanning electron microscope, a cathodoluminescence microscope, or a fluorescent microscope.

The regrowth interface may be present when a step of growing the GaN crystal layer and a step of growing the Si-doped GaN layer are not continuous.

The conductivity type of the Si-doped GaN layer in the GaN substrates according to both embodiments, that is, the carrier type is generally n-type.

The specific resistance at 300 K of the Si-doped GaN layers in both embodiments is preferably 1 × 10⁻² Ωcm or less, more preferably 8 × 10⁻³ Ωcm or less, and still more preferably 4 × 10⁻³ Ωcm or less. The specific resistance is preferably as low as possible, and is generally 1 × 10⁻⁵ Ωcm or more.

The lower the specific resistance is, the higher the electron mobility is. It is possible to obtain a high-output nitride semiconductor device by which a high-temperature operation and a high-speed operation can be performed.

The specific resistance of the Si-doped GaN layer is obtained by connecting a terminal to the Si-doped GaN layer and performing a measurement using a four-terminal Van der Pauw method.

The GaN substrates according to both embodiments are preferably used as a wafer. A shape of the main surface may be square, rectangular, hexagonal, octagonal, elliptical, or the like, and is not particularly limited. Further, the shape may be irregular.

As compared with the GaN substrate according to the first embodiment, in the GaN substrate according to the related art, a continuous surface without a recessed defect or a recessed portion having a depth of 5 µm or more cannot be produced on a surface of a Si-doped GaN layer. Even when the surface without a recessed defect or a recessed portion is cut out, only a small-piece size is obtained. In contrast, in the Si-doped GaN layer according to the first embodiment, a surface without a recessed defect and a recessed portion can be produced without cutting, and a GaN substrate having a large area in which the total of the bottom areas of the recessed defects or the total of the bottom areas of the recessed portions each having a depth of 5 µm or more is 15% or less of the area of the entire surface of the Si-doped layer can be obtained.

That is, when the GaN substrate according to the first embodiment is a wafer, the wafer preferably has a diameter of 25 mm or more. In the GaN substrates according to both embodiments, the diameter of the GaN substrate when it is a wafer is generally 45 mm or more, may be 50 mm or more, may be 95 mm or more, or may be 145 mm or more, in view of nitride semiconductor applications. Typically, the diameter of the GaN substrate is 50 mm to 55 mm (about 2 inches), 100 mm to 105 mm (about 4 inches), 150 mm to 155 mm (about 6 inches), or the like.

In addition, when the GaN crystal has a shape other than the disk shape, a size where the diameter of the disk shape having the same area as the main surface reaches the above size can be adopted.

The preferable thickness of the GaN substrate varies depending on the diameter of the main surface.

When the diameter is about 2 inches, the thickness of the GaN substrate is preferably 250 µm to 450 µm. Here, the above thickness is preferably 250 µm or more, more preferably 300 µm or more, and still more preferably 350 µm or more, and is preferably 450 µm or less, and more preferably 400 µm or less.

When the diameter is about 4 inches, the thickness of the GaN substrate is preferably 350 µm to 750 µm. Here, the above thickness is preferably 350 µm or more, and more preferably 400 µm or more, and is preferably 750 µm or less, more preferably 650 µm or less, and still more preferably 600 µm or less.

When the diameter is about 6 inches, the thickness of the GaN substrate is preferably 450 µm to 800 µm. Here, the above thickness is preferably 450 µm or more, more preferably 550 µm or more, and is preferably 800 µm or less, and more preferably 700 µm or less.

When the GaN substrate is formed of only the Si-doped GaN layer, the thickness of the Si-doped GaN layer is preferably within the above range.

A (000-1) surface 102, which is an N-polar surface of the GaN substrates according to both embodiments, may be mirror-finished as a back surface, or may be rough-finished or matte finished.

A (0001) surface 101, which is a Ga-polar plane of the GaN substrate, is used as a front surface, and a nitride semiconductor layer is further epitaxially grown on the front surface and used for a nitride semiconductor device.

The (0001) surface 101, which is a Ga-polar plane, may be a surface in an as-grown state in which the crystal remains in growth, and is preferably a surface planarized by processing such as polishing, chemical mechanical polishing (CMP), or etching. Further, the (0001) surface 101 may be a surface formed by cutting, or may be a surface on which only the above flattening is performed without cutting.

The root mean square roughness (RMS) of the (0001) surface 101 of the GaN substrates according to both embodiments measured with an atomic force microscope (AFM) is preferably less than 5 nm, more preferably less than 2 nm, still more preferably less than 1 nm, and may be less than 0.5 nm in a measurement range of 2 µm × 2 µm.

An edge of the GaN substrates according to both embodiments may be chamfered. Further, the GaN substrate can be provided with various markings as necessary, such as orientation flats or notches for indicating an orientation of a crystal, and an index flat for facilitating the identification of a front surface and a back surface.

The semiconductor device using the GaN substrates according to both embodiments is basically a nitride semiconductor device. The nitride semiconductor device is a semiconductor device in which a main portion of a device structure is formed of a nitride semiconductor.

The above nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

The type of the nitride semiconductor device using the GaN substrates according to both embodiments is not limited, and examples thereof include light emitting devices such as a laser diode (LD) and a light emitting diode (LED), and electronic devices such as a rectifier, a bipolar transistor, and a field-effect transistor.

### [Method for Producing GaN substrate (1)]

A method for producing the GaN substrate according to the first embodiment and a method for producing the GaN substrate according to the second embodiment are not particularly limited as long as desired characteristics are obtained.

As a result of intensive studies by the present inventors, the present inventors have found that the GaN substrate according to the first embodiment or the GaN substrate according to the second embodiment can be produced by using a vapor phase growth method in forming the Si-doped GaN layer and setting an off-angle of the base crystal at that time within a specific range as one aspect of the above production method.

Therefore, a third embodiment of the present invention relates to a method for producing a Si-doped GaN layer in which a total of bottom areas of recessed defects on a surface of the Si-doped GaN layer is 15% or less of an area of the entire surface, a Si-doped GaN layer in which a total of bottom areas of recessed portions each having a depth of 5 µm or more is 15% or less of the area of the entire surface, or a Si-doped GaN layer in which a value represented by {(b/a) × 100} (%) is 90% or more, in which a (atoms/cm³) represents a Si concentration, and b (atoms/cm³) represents a carrier concentration.

An aspect of a method for producing a Si-doped GaN layer according to the third embodiment is a method for producing a Si-doped GaN layer having a thickness of 50 µm or more on a base crystal according to a vapor phase growth method, and is characterized in that an off-angle of the above base crystal is 0.5° or more.

Another aspect of the method for producing a Si-doped GaN layer according to the third embodiment is a method for producing a Si-doped GaN layer having a Si concentration of 1 × 10¹⁸ atoms/cm³ or more on a base crystal by a vapor phase growth method, and is characterized in that an off-angle of the above base crystal is 0.5° or more.

That is, an aspect of the method for producing the GaN substrate according to the first embodiment and the method for producing the GaN substrate according to the second embodiment includes the method for producing the Si-doped GaN layer according to the third embodiment as one step.

A Si concentration of the Si-doped GaN layer produced by the method for producing the Si-doped GaN layer of the third embodiment is preferably 1 × 10¹⁸ atoms/cm³ or more.

The base crystal on which the Si-doped GaN layer is formed is preferably a c-plane GaN substrate seed, and a Si-doped GaN layer, that is, a (0001)-oriented GaN layer doped with Si is grown on a surface of the base crystal by a vapor phase growth method.

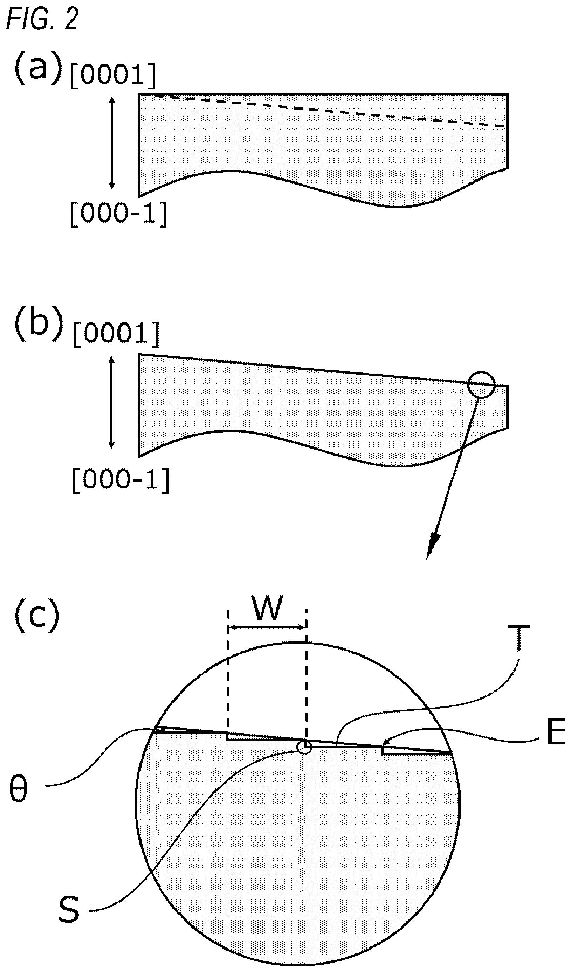

FIG. 2 is a view illustrating the off-angle provided in the base crystal used in the method for forming the Si-doped GaN layer, and in FIG. 2 (a), the (0001) surface of the base crystal is obliquely cut out as indicated by a broken line.

FIG. 2 (b) illustrates the base crystal after cutting, and of FIG. 2 (c) is an enlarged view of a part surrounded by a circle.

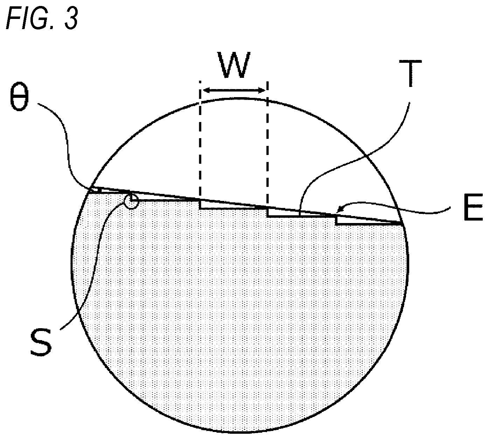

As shown in FIG. 2 (c), an angle at which the (0001) surface of the base crystal is cut out is referred to as an off-angle θ, and by cutting a cut surface is formed in a stepped shape having a step of a thickness of one atom. A terrace width W representing a width of a terrace T varies depending on the off-angle θ during cutting. That is, the smaller the off-angle θ is, the larger the terrace width W is. As compared with FIG. 2 (c), the terrace width W is reduced as the off-angle θ is increased as shown in FIG. 3.

Here, the terrace width W becomes narrow by setting the off-angle θ to 0.5° or more, and on the surface of the obtained Si-doped GaN layer, the total of the bottom areas of the recessed defects or the total of the bottom areas of the recessed portions each having a depth of 5 µm or more can be 15% or less of the area of the entire surface of the Si-doped GaN layer, and the GaN crystal according to the first embodiment is obtained.

The reason for this is unclear, but is considered to be as follows.

When the Si-doped GaN layer is formed by the vapor phase growth method, a gas containing Si atoms and a gas containing N atoms are used as raw materials. As described above, when Si atoms and N atoms are in a gas phase state, the Si atoms and the N atoms hardly react to form silicon nitride, which causes cissing. However, it is considered that when Si adsorbed on the terrace T, that is, Si adatoms and molecules containing N atoms adsorbed on the terrace T meet each other by thermal motion or the like, and react to form cissing.

As shown in FIG. 2 (c), the larger the terrace width W is, the longer the time for the Si adatom adsorbed on the surface of the terrace T moving to and reaching a step end E. The step end E has the kink site S which is the necessary growth site for being incorporated into the GaN crystal. Then, while the Si adatom moves to the step end E, the Si adatom encounters and reacts with the N atom adsorbed on the surface of the terrace, so that the probability of cissing occurring increases.

In contrast, as illustrated in FIG. 3, it is considered that the terrace width W becomes narrow by making the off-angle θ of the base crystal larger than that in the related art. As a result, the encounter probability between the Si adatom and the adsorbed N atom in the terrace T can be reduced, so that the occurrence of cissing can be prevented.

When high doping with Si is performed so that the Si concentration of the Si-doped GaN layer is a high concentration of, for example, 1 × 10¹⁸ atoms/cm³ or more, the Si adatoms encounter and react with the adsorbed N atoms as the density of the Si adatoms on the terrace T increases, and a large number of cissing portions are formed according to the related art. However, when the off-angle θ is set to 0.5° or more, the Si adatom reaches the step end E having the kink site S without forming cissing, and Si is incorporated into the kink site S. As a result, even when epitaxial growth is performed, the obtained Si-doped GaN layer has a smooth surface with few recessed portions.

In order to shorten the movement time for the Si adatom on the terrace T reaching the step end E as described above, it is conceivable to change growth conditions for the crystal growth. However, it has been found that the growth temperature needs to be increased in units of 100°C in order to shorten the above movement time by changing, for example, the growth temperature.

Such a high temperature is not realistic, and for example, when the crystal growth of GaN at 1000°C is performed at 1100°C, GaN is decomposed and cannot be grown.

Similarly, regarding the GaN substrate according to the second embodiment, the terrace width W becomes narrow when the off-angle θ of the base crystal is set to 0.5° or more, and the value represented by {(b/a) × 100} (%) can be 90% or more, in which a (atoms/cm³) represents a Si concentration of the obtained Si-doped GaN layer, and b (atoms/cm³) represents a carrier concentration of the obtained Si-doped GaN layer.

The reason for this is unclear, but is considered to be as follows.

A relationship between the off-angle θ and the terrace width W is as described above. However, the off-angle θ in the related art is, for example, about 0.3°, and when the base crystal is cut out at this angle, the terrace T is wide, and the probability that Si atoms do not enter the Ga site, which is the original position, but enter the interstitial site, the anti-site (N site), or the like increases. The terrace width W in the case where the off-angle θ is 0.3° is about 1.5 times the terrace width in the case where the off-angle θ is 0.5°.

In contrast, it is considered that when the off-angle is set to 0.5° or more, the terrace width W becomes reduced, and the movement distance for the Si adatom to reach the kink site S can be shortened, so that the Si atom is incorporated into an appropriate kink site and can function as a dopant. As a result, it is considered that the Si concentration is increased from the viewpoint of resistance reduction, and as a result, the Si atom is incorporated into an appropriate kink site even if the density of the Si adatom in the terrace T increases, and therefore, a high activation rate can be achieved.

Therefore, in order to obtain the Si-doped GaN layer in both embodiments, the off-angle of the base crystal in the third embodiment is preferably 0.5° to 1°. Here, the above off-angle is preferably 0.5° or more, more preferably 0.55° or more, and still more preferably 0.6° or more. On the other hand, from the viewpoint of preventing bunching and maintaining the plane orientation characteristics of the C plane, the above off-angle is preferably 1° or less, more preferably 0.9° or less, and still more preferably 0.8° or less.

The GaN substrates according to the first and second embodiments can be obtained by adopting a common production method for other factors besides the off-angle of the base crystal.

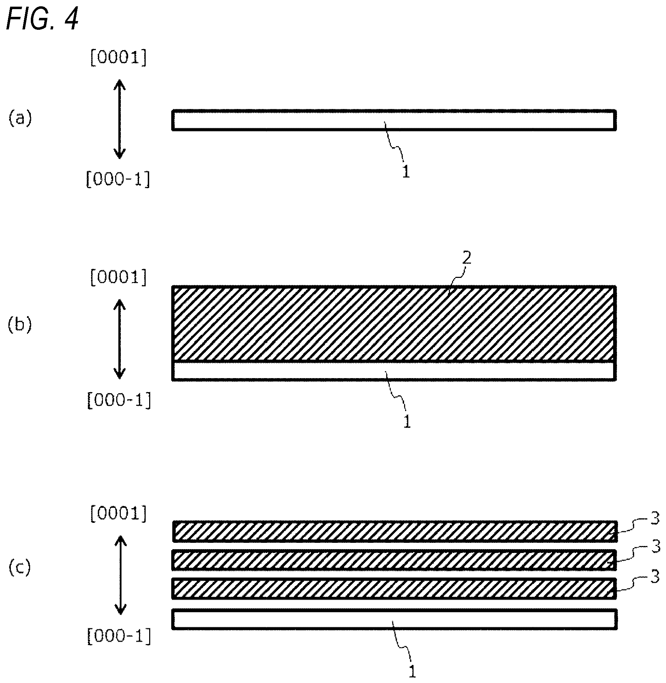

For example, a seed wafer 1 was prepared as shown in FIG. 4 (a), and a (0001)-oriented first thick GaN film 2 made of GaN that is not intentionally doped is grown on the seed wafer 1 by the HVPE method as shown in FIG. 4 (b). Further, as shown in FIG. 4 (c), the first thick GaN film 2 may be processed as necessary to obtain a plurality of first c-plane GaN wafers 3.

An example of the seed wafer 1 is a c-plane sapphire wafer, and the seed wafer 1 is preferably provided with a release layer on a main surface thereof. When the release layer is provided, a GaN layer having a thickness of several hundreds of nanometers is grown on a c-plane sapphire wafer via a low-temperature buffer layer by a metalorganic vapor phase epitaxy (MOVPE) method, and a Ti (titanium) layer having a thickness of several tens of nanometers is formed on the above GaN layer by vacuum deposition. Thereafter, the release layer can be formed by, for example, annealing at 1060°C for 30 minutes in a mixed gas atmosphere of 80% H₂ (hydrogen) and 20% NH₃ (ammonia).

It is preferable that the first GaN thick film 2 is preferably thick enough to form the free-standing first c-plane GaN wafer 3, and it is preferable that the first GaN thick film 2 is grown to a thickness of, for example, several millimeters or more to obtain two or more first c-plane GaN wafers 3 therefrom.

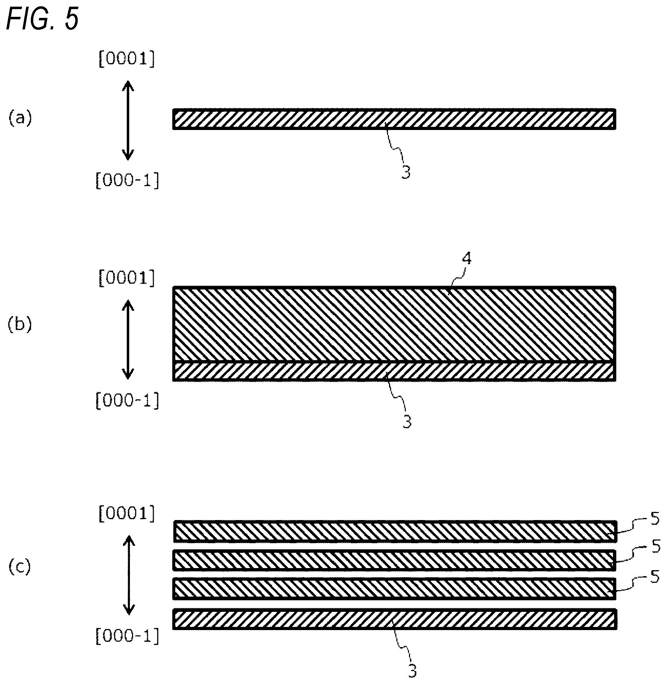

On the (0001) crystal plane of the Ga-polar plane of the first c-plane GaN wafer 3 obtained above as shown in FIG. 5 (a), a (0001)-oriented second thick GaN film 4 made of GaN that is not intentionally doped is grown by the HVPE method as shown in FIG. 5 (b). Then, as shown in FIG. 5 (c), the second thick GaN film 4 may be processed as necessary to obtain a plurality of second c-plane GaN wafers 5.

The second c-plane GaN wafer 5 obtained as described above serves as a base crystal when the Si-doped GaN layer is formed, but may be appropriately subjected to planarization processing using techniques such as grinding, polishing, or CMP as desired before obliquely cutting the (0001) crystal plane of the Ga-polar plane. After the planarization, surface roughening using etching may be performed.

A common method can be applied to the planarization processing and the surface roughening processing.

As described above, the off-angle, which is an inclination angle when obliquely cutting out the (0001) crystal plane of the Ga-polar plane, is preferably 0.5° or more. The off-cut direction, which is an inclination direction, is preferably a m-axis direction or an a-axis direction.

The (0001) crystal plane of the GaN crystal layer can be cut using a wire slicing device or a laser slicing device.

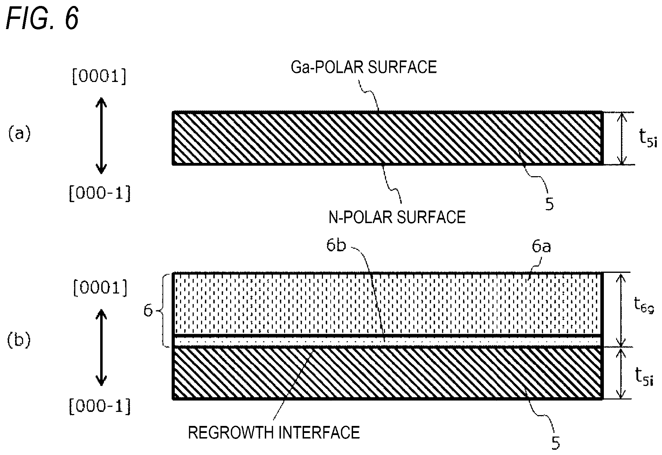

A Si-doped GaN layer 6a is formed on the (0001) crystal plane of the second c-plane GaN wafer 5 whose surface is cut out as shown in FIG. 6 (a). An interposed region 6b having a Si concentration of less than 1 × 10¹⁸ atoms/cm³ may be present between the second c-plane GaN wafer 5 and the Si-doped GaN layer 6a as shown in FIG. 6 (b).

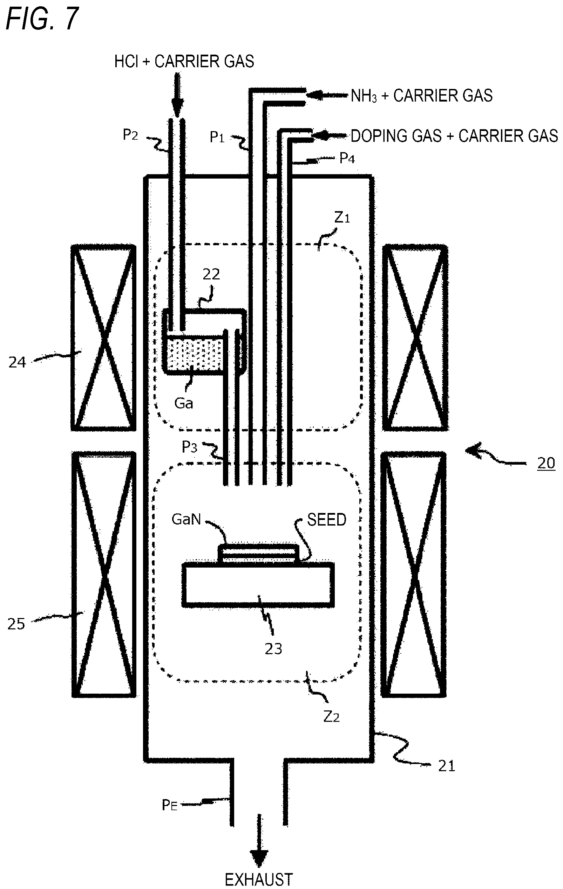

When the above GaN crystal or GaN crystal doped with Si is grown by the HVPE method, for example, an HVPE device 20 shown in FIG. 7 can be used.

An HVPE device 20 illustrated in FIG. 7 includes a hot-wall reactor 21, a gallium reservoir 22 and a susceptor 23 disposed in the reactor 21, and a first heater 24 and a second heater 25 disposed outside the reactor 21. The first heater 24 and the second heater 25 each annularly surround the reactor 21.

The reactor 21 is a quartz tube chamber. The reactor 21 includes a first zone Z1 mainly heated by the first heater 24 and a second zone Z2 mainly heated by the second heater 25. An exhaust pipe P_{E} is connected to an end of the reactor 21 on a second zone Z2 side.

The gallium reservoir 22 disposed in the first zone Z1 is a quartz container having a gas inlet and a gas outlet.

The susceptor 23 disposed in the second zone Z2 is formed of, for example, graphite. A mechanism for rotating the susceptor 23 may be freely provided.

In order to grow GaN by the HVPE device 20, a seed is placed on the susceptor 23, and an inside of the reactor 21 is heated by the first heater 24 and the second heater 25. At the same time, NH₃ (ammonia) diluted with a carrier gas is supplied to the second zone Z2 through an ammonia introduction pipe P₁, and HCl (hydrogen chloride) diluted with a carrier gas is supplied to the gallium reservoir 22 through a hydrogen chloride introduction pipe P₂. HCl reacts with the metallic gallium in the gallium reservoir 22, and the generated GaCl (gallium chloride) is carried to the second zone Z2 through a gallium chloride introduction pipe P₃.

NH₃ reacts with GaCl in the second zone Z2, and the generated GaN is crystallized on the seed placed on the susceptor 23.

When growing GaN is to be intentionally doped, a doping gas diluted with a carrier gas is guided to the second zone Z2 in the reactor 21 through a dopant introduction pipe P₄.

Portions of the ammonia introduction pipe P₁, the hydrogen chloride introduction pipe P₂, the gallium chloride introduction pipe P₃, and the dopant introduction pipe P₄ disposed in the reactor 21 are formed of quartz.

As the carrier gas for diluting each of NH₃, HCl, and the doping gas, H₂ (hydrogen gas), N₂ (nitrogen gas), or a mixed gas of H₂ and N₂ is preferably used.

Preferred conditions for growing GaN using the HVPE device 20 are as follows.

The temperature of the gallium reservoir 22 is, for example, 500°C to 1000°C, and preferably 700°C or higher, and is preferably 900°C or lower.

The temperature of the susceptor 23 is, for example, 900°C to 1100°C, preferably 930°C or higher, and more preferably 950°C or higher, and is preferably 1050°C or lower, and more preferably 1020°C or lower.

The V/III ratio, which is a ratio of a NH₃ partial pressure (V) to the GaCl partial pressure (III) in the reactor 21, is, for example, 1 to 20, preferably 2 or more, and more preferably 3 or more, and is preferably 10 or less.

An excessively small or excessively large V/III ratio causes the morphology of the GaN growth surface to deteriorate. Deterioration in the morphology of the growth surface may cause deterioration in the crystal quality.

The growth rate of GaN can be controlled using a product of NH₃ partial pressure and the GaCl partial pressure in the reactor as a parameter. The above growth rate is, for example, 20 µm/h to 200 µm/h, and when the Si-doped GaN layer is grown, the growth rate is preferably 120 µm/h or less, more preferably 100 µm/h or less, and still more preferably 80 µm/h or less.

An excessively high growth rate causes the surface morphology of growing GaN to deteriorate.

When doping is performed with Si, it is preferable to gradually increase a supply rate of the doping gas to a predetermined value over several minutes or several tens of minutes from the start of the supply in order to prevent deterioration in morphology of the growth surface.

For the same reason, the supply of the doping gas is preferably started at a time point when the GaN layer is grown by at least several micrometers.

The doping gas for doping with Si is preferably SiH₄ (silane), SiH₃Cl (monochlorosilane), SiH₂Cls (dichlorosilane), SiHCl₃ (trichlorosilane), or SiCl₄ (tetrachlorosilane).

The partial pressure of the doping gas for doping with Si is preferably 1 × 10⁻⁶ to 2 × 10⁻⁴ kPa, more preferably 2 × 10⁻⁶ kPa or more, and more preferably 1 × 10⁻⁴ kPa or less.

A molar ratio of H₂ in the carrier gas may affect the impurity concentration of GaN to be grown. Here, the molar ratio of H₂ in the carrier gas is calculated based on the flow rate of each gas species supplied as the carrier gas from outside the reactor into the reactor.

The O concentration of GaN grown by the HVPE method during doping with Si tends to decrease as the molar ratio of H₂ in the carrier gas increases, and can be 2 × 10¹⁶ atoms/cm³ or less, and further 1 × 10¹⁶ atoms/cm³ or less. This is because the surface morphology during growth is improved.

The GaN grown using an HVPE device 10 can contain O at a concentration detectable by SIMS even when the GaN is not intentionally doped with O. The O source is either one or both of quartz (SiO₂) used for a reactor and a pipe in the reactor, and moisture remaining or entering the reactor. In addition to Si from a doping gas, the Si source may be quartz (SiO₂) used for the reactor and the pipe in the reactor.

The components disposed in the reactor 11, including components not shown in FIG. 7, may be those formed of SiC (silicon carbide), SiNx (silicon nitride), BN (boron nitride), alumina, W (tungsten), Mo (molybdenum), or the like, in addition to quartz and carbon. Accordingly, the concentration of each impurity other than Si, O, and H in GaN grown using the HVPE device 10 can be set to 5 × 10¹⁵ atoms/cm³ or less unless intentional doping is performed.

In the method for producing the Si-doped GaN layer of the third embodiment, the Ga-polar plane of the produced Si-doped GaN layer may be a surface in an as-grown state in which the crystal remains in growth, and may include a step of planarizing the surface. In the planarization step, a known processing method such as polishing, chemical mechanical polishing (CMP), and etching can be used.

The method for producing the Si-doped GaN layer of the third embodiment may include a step of obtaining one or a plurality of free-standing GaN substrates by slicing the Si-doped GaN layer having a thickness of 50 µm or more produced on the base crystal. In this case, a thick Si-doped GaN layer is grown to the extent that a free-standing GaN substrate can be obtained.

When a free-standing GaN substrate is obtained by slicing a Si-doped GaN substrate, the plane orientation of the main surface cut out during slicing can be freely adjusted. For example, when the free-standing GaN substrate is sliced from the Ga-polar plane of the Si-doped GaN layer in the as-grown state so as to have a lower off-angle, the GaN substrate having the Si-doped GaN layer whose main surface has a low off-angle can be obtained. The GaN substrates according to the first and second embodiments can also be obtained according to this method. In this case, the off-angle of the main surface of the obtained GaN substrate does not necessarily required to coincide with the off-angle of the main surface of the base crystal used in the production step.

### [GaN Substrate (2)]

In an aspect of the GaN substrate according to the fourth embodiment , the GaN substrate has a main surface 1 inclined by 0° to 10° from a (0001) crystal plane which is a Ga-polar plane, and has a Si-doped GaN layer on at least a surface of the main surface 1. The Si-doped GaN layer has a Si concentration of 1 × 10¹⁸ atoms/cm³ or more. Further, a value represented by [{(α - β)/α} × 100] (%) is 10% or less, in which α (atoms/cm³) represents the maximum value of the Si concentration of the surface of the above Si-doped GaN layer, and β (atoms/cm³) represents the minimum value thereof.

In another aspect of the GaN substrate according to the fourth embodiment, the GaN substrate has the main surface 1 inclined by 0° to 10° from the (0001) crystal plane, which is a Ga-polar plane, and has a Si-doped GaN layer on the surface of at least the main surface 1. The Si concentration of the Si-doped GaN layer is 1 × 10¹⁸ atoms/cm³ or more, and a thickness of the Si-doped GaN layer is 50 µm or more. Further, the value represented by [{(α - β)/α} × 100] (%) is 10% or less, in which α (atoms/cm³) represents the maximum value of the Si concentration of the surface of the above Si-doped GaN layer, and β (atoms/cm³) represents the minimum value thereof.

In the fourth embodiment, the above main surface 1 inclined from the (0001) crystal plane may be by 0° to 10°, and is preferably by 0° to 5°, and more preferably by 0° to 2.5°. A lower limit of the inclination is 0°, and the inclination may be 0.2° or more. An upper limit of the inclination is 10°, and the inclination is preferably 5° or less, more preferably 2.5° or less, may be 1.5° or less, or may be 1° or less.

In the fourth embodiment, the GaN substrate has a Si-doped GaN layer on the above main surface 1. In the present description, "has a Si-doped GaN layer on the surface of main surface 1 " means that an outermost surface of the main surface 1 of the GaN substrate coincides with an outermost surface of the Si-doped GaN layer.

In the fourth embodiment, as illustrated in FIG. 1, a GaN substrate 100 may be (0001)-oriented, and may have a GaN crystal layer 120 and a Si-doped GaN layer 110 on a (0001) surface 101, which is a Ga-polar plane side. After the Si-doped GaN layer 110 is formed, the GaN crystal layer 120 used as a base crystal may be removed to form the GaN substrate 110 including only the Si-doped GaN layer 110.

The (0001)-oriented GaN substrate refers to a substrate having a (0001) crystal plane, that is, a main surface parallel or substantially parallel to the c-plane, that is, a large-area plane, and is also referred to as a c-plane GaN substrate. Here, the expression "parallel or substantially parallel" means that the inclination from the (0001) crystal plane, which is the Ga-polar plane, is 0° to 10°.

The Si-doped GaN layer 110 in the fourth embodiment means a layer obtained by substituting a part of Ga of a GaN crystal with Si.

The Si concentration of the Si-doped GaN layer 110 is 1 × 10¹⁸ atoms/cm³ or more. Accordingly, the resistance reduction can be achieved, and is useful as a conductive substrate. From the viewpoint of the resistance reduction, the Si concentration of the Si-doped GaN layer 110 is preferably 2 × 10¹⁸ atoms/cm³ or more, still more preferably 5 × 10¹⁸ atoms/cm³ or more, yet still more preferably 7 × 10¹⁸ atoms/cm³ or more, and particularly preferably 9 × 10¹⁸ atoms/cm³ or more, and is preferably as high as possible. An upper limit of the Si concentration is not particularly limited, and the Si concentration is, for example, 1 × 10²¹ atoms/cm³ or less.

In the present description, a concentration of donor impurities such as Si (silicon) in the Si-doped GaN layer can be determined by secondary ion mass spectrometry (SIMS). The donor impurity concentration such as the Si concentration may vary along a c-axis direction, but an average of the donor impurity concentrations from a depth of 3 µm to a depth of 50 µm from the Si-doped GaN layer surface can be defined as the donor impurity concentration.

As the Si concentration of the Si-doped GaN layer 110 increases, it is more difficult to make the Si concentration uniform in a direction parallel to the main surface 1. This is considered to be caused by deactivation due to a reaction between a reaction precursor such as silane chloride used for doping with Si and NH₃ or the like that is a raw material of an N atom.

When an attempt is made to form a Si-doped GaN layer having a Si concentration of 1 × 10¹⁸ atoms/cm³ or more, deactivation of the above reaction precursor is particularly remarkable at an end portion of the substrate. As a result of a decrease in the incorporation concentration of Si, the resistance reduction is inhibited. Therefore, it is considered that the semiconductor device produced at an end portion of the substrate has a high resistance on a negative electrode side.

In contrast, in the Si-doped GaN layer 110 according to the fourth embodiment, the resistance reduction corresponding to the Si concentration can be uniformly achieved in the entire substrate even when the Si concentration is high.

Details of a mechanism by which such a substrate is obtained are not clear, but are considered as follows.

The reason why the Si atom does not enter the Ga site which is an original position, but enters, for example, the interstitial site or the anti-site (N site) is considered to be that the terrace is wide and a movement distance until the Si atom is incorporated into the kink site is long.

In contrast, in the present invention, it is considered that the distance for the Si atom to reach the kink site is shortened by narrowing the terrace, and the Si atom is easily incorporated into an appropriate kink site. In addition, it is considered that by increasing the distance L between a GaCl gas ejection nozzle port and a surface of the substrate as compared with the related art, the diffusibility of the gas is enhanced, and Si atoms are well incorporated not only in the region close to the ejection nozzle of the substrate but also the end portion of the substrate. As a result, it is considered that the uniformity of the Si concentration is improved, and a GaN substrate in which the resistance reduction corresponding to the Si concentration is uniformly achieved in the entire substrate is obtained.

In the fourth embodiment, a value represented by [{(α - β)/α} × 100] (%) is 10% or less, in which α (atoms/cm³) represents the maximum value of the Si concentration of the surface of the Si-doped GaN layer, and β (atoms/cm³) represents the minimum value thereof. The value is preferably 8% or less, more preferably 5% or less, still more preferably 3% or less, and particularly preferably 2% or less. The value is preferably as low as possible, and is generally 0.01% or more.

The maximum value α (atoms/cm³) and the minimum value β (atoms/cm³) of the Si concentration on the surface of the Si-doped GaN layer are specifically measured by the following method.

First, the Si concentrations are measured by the SIMS at three positions on the surface of the Si-doped GaN layer including a center portion, the position that is 12.5 mm from a center, and a position that is 25 mm from the center. Generally, a region close to the center of the Si-doped GaN layer has the maximum value α of the Si concentration. On the other hand, generally, a region near an end portion of the Si-doped GaN layer has the minimum value β (atoms/cm³) of the Si concentration. Among the Si concentrations measured at the above-described three points, the maximum value is adopted as α, and the minimum value is adopted as β.

The above description does not limit the size of the GaN substrate. For example, when the GaN substrate is a wafer having a diameter of 50 mm or more, the above description can be applied as it is. However, when the GaN substrate is a square substrate having a short diameter of less than 50 mm, a wafer having a diameter of less than 50 mm, or the like, a position of 12.5 mm from the center or a position of 25 mm from the center may not be present. In this case, the Si concentration may be measured by SIMS at three points including a central portion, an end portion, and a midpoint between the above center portion and end portion on the surface of the Si-doped GaN layer, and the maximum value and the minimum value may be adopted as α and β, respectively.

It can be said that as the value represented by [{(α - β)/α} × 100] (%) is small, that is, as the difference between the maximum value α and the minimum value β of the Si concentration is small, the resistance reduction corresponding to the concentration of Si with which doping is performed can be uniformly performed in the entire substrate.

In the fourth embodiment, the thickness of the Si-doped GaN layer is preferably 50 µm or more. Accordingly, even the Si-doped GaN layer alone has a self-supporting property, and even when the GaN substrate is formed of only the Si-doped GaN layer, the Si-doped GaN layer can serve as a substrate.

The thickness of the Si-doped GaN layer is preferably 50 µm to 300 µm. Here, the above thickness is preferably 50 µm or more, more preferably 80 µm or more, and still more preferably 100 µm or more. The upper limit of the thickness is not particularly limited, and the thickness is, for example, 300 µm or less, may be 200 µm or less, and may be 150 µm or less.

The thickness of the Si-doped GaN layer in the present description is the thickness of a layer having a Si concentration of 1 × 10¹⁸ atoms/cm³ or more, and can be measured by the above-described SIMS. When the thickness of the Si-doped GaN layer is not uniform, the smallest thickness may be in the above range.

In the fourth embodiment, the Si-doped GaN layer may contain group 14 elements such as Ge (germanium) or group 16 elements such as O (oxygen) and S (sulfur) as donor impurities in addition to Si (silicon). A total concentration of the donor impurities other than Si is, for example, 10% or less of the Si concentration, may be 5% or less, may be 1% or less, or may be 0% of the Si concentration (not contained).

As described below, the GaN substrate according to the fourth embodiment is preferably crystal-grown by, for example, a vapor phase growth method, and more preferably a hydride vapor phase epitaxy (HVPE) method.

The Si-doped GaN layer obtained by the above method may contain O (oxygen) at a concentration on the order of 10¹⁵ atoms/cm³ or more even when O is not intentionally added. That is, the Si-doped GaN layer may have an O (oxygen) concentration of 1 × 10¹⁵ atoms/cm³ or more.

On the other hand, donor impurities other than Si and O are contained in the Si-doped GaN layer at a non-negligible concentration only when the GaN substrate is intentionally doped with such donor impurities. Note that "intentionally doping" means, for example, a case where the element is added in the form of a simple substance or a compound as a raw material in order to dope the Si-doped GaN layer with the target element.

Therefore, unless the Si-doped GaN layer is intentionally doped with the donor impurities other than Si and O, the total donor impurity concentration of the Si-doped GaN layer may be considered to be equal to the sum of the Si concentration and the O concentration.

Whether the Si-doped GaN layer is doped with the donor impurities other than Si and O can be checked by an elemental analysis or the like.

From the viewpoint of crystallinity, the concentration of each of the donor impurities other than Si is preferably 1 × 10¹⁷ atoms/cm³ or less, more preferably 8 × 10¹⁶ atoms/cm³ or less, and still more preferably 5 × 10¹⁶ atoms/cm³ or less. In addition, for the same reason, the total concentration of the donor impurities other than Si is preferably 2 × 10¹⁷ atoms/cm³ or less, more preferably 8 × 10¹⁶ atoms/cm³ or less, and still more preferably 5 × 10¹⁶ atoms/cm³ or less.

The Si-doped GaN layer may contain elements other than Ga, N, and Si, which constitute the GaN crystal, and the group 14 element and the group 16 element atoms serving as other donor impurities. Other elements may be intentionally contained or unintentionally and inevitably contained, and examples thereof include H (hydrogen), C (carbon), Cl (chlorine), and the like. The total concentration of these other elements may be on the order of 10¹⁶ atoms/cm³ to 10¹⁷ atoms/cm³.

The full width at half maximum of a X-ray diffraction rocking curve of a (004) plane of the Si-doped GaN layer is preferably 50 arcsec or less. The rocking curve is a diffraction intensity distribution in the case where a direction of incident X-rays and a position of a detector are fixed and only a crystal as a sample is rotated in an X-ray diffraction measurement, and is one of indexes indicating crystal quality.

A smaller value of the full width at half maximum of the rocking curve means that the fewer crystal defects and the better crystal quality. The full width at half maximum is preferably 40 arcsec or less, more preferably 30 arcsec or less, and still more preferably 20 arcsec or less. The lower limit of the full width at half maximum is not particularly limited, and the full width at half maximum is generally 5 arcsec or more. The full width at half maximum in the present description has the same meaning as the half width in general. That is, the half width means a distance between positions indicating an intensity 1/2fₘₐₓ which is half the maximum intensity fₘₐₓ of a peak.

The full width at half maximum can be adjusted by a method of growing a GaN crystal layer in the Si-doped GaN layer (a vapor phase method, a liquid phase method, or the like), the crystal characteristics, crystal growth conditions, selection of a surface for growth, the content of impurities, and the like of a seed substrate used for growing a GaN crystal layer.

In the fourth embodiment, the dislocation density on the surface of the Si-doped GaN layer is preferably 5 × 10⁶ cm⁻² or less. In this case, the device performance deterioration due to dislocation can be prevented. From the same viewpoint, the dislocation density in the surface of the Si-doped GaN layer is more preferably 2 × 10⁶ cm⁻² or less, and still more preferably 1 × 10⁶ cm⁻² or less.

The dislocation density of the Si-doped GaN layer is preferably equal to or higher than the dislocation density of the GaN crystal layer which is the base crystal layer, and more specifically, is preferably 0.5 times or more and less than 2 times the dislocation density of the GaN crystal layer which is the base crystal layer. The fact that both dislocation densities are the same or substantially the same means that no new dislocation is generated at an interface between the GaN crystal layer and the Si-doped GaN layer.

In the fourth embodiment, the GaN crystal layer on which the Si-doped GaN layer is to be formed becomes a base crystal and is a layer in which GaN is epitaxially grown. The GaN crystal layer may have a specific resistance of less than 1 × 10⁵ Ωcm at room temperature, that is, may not be a layer of semi-insulating.

In the fourth embodiment, the GaN crystal layer may unintentionally and inevitably contain Si, O, H, or the like as an element other than Ga and N. For example, the Si concentration may be 5 × 10¹⁷ atoms/cm³ or less. The O concentration may be 2 × 10¹⁷ atoms/cm³ or less. The H concentration may be 5 × 10¹⁶ atoms/cm³ or less. The concentration of each of elements other than Si, O, and H may be 5 × 10¹⁵ atoms/cm³ or less.

In the fourth embodiment, when the GaN substrate is used for producing a nitride semiconductor device, the GaN crystal layer may be removed, and the Si-doped GaN layer may be used for a nitride semiconductor device chip. In such a mode of use, there is no particular requirement for electrical characteristics of the GaN crystal layer.

The Si-doped GaN layer in the GaN substrate may be formed directly on the c-plane of the GaN crystal layer or may be formed via a regrowth interface.

The regrowth interface means an interface generated when a crystal to be the Si-doped GaN layer is grown on the GaN crystal layer. The presence of the regrowth interface can be confirmed by, for example, observing a cross section of the GaN substrate wafer using a scanning electron microscope, a cathodoluminescence microscope, or a fluorescent microscope.

The regrowth interface may be present when a step of growing the GaN crystal layer and a step of growing the Si-doped GaN layer are not continuous.

The conductivity type of the Si-doped GaN layer in the GaN substrate according to the fourth embodiment, that is, the carrier type is generally n-type.

The specific resistance at 300 K of the Si-doped GaN layers in the fourth embodiment is preferably 1 × 10⁻² Ωcm or less, more preferably 8 × 10⁻³ Ωcm or less, and still more preferably 4 × 10⁻³ Ωcm or less. The specific resistance is preferably as low as possible, and is generally 1 × 10⁻⁵ Ωcm or more.

The lower the specific resistance is, the higher the electron mobility is. It is possible to obtain a high-output nitride semiconductor device by which a high-temperature operation and a high-speed operation can be performed.

The specific resistance of the Si-doped GaN layer is obtained by connecting a terminal to the Si-doped GaN layer and performing a measurement using a four-terminal Van der Pauw method.

The GaN substrate according to the fourth embodiment is preferably used as a wafer. A shape of the main surface may be square, rectangular, hexagonal, octagonal, elliptical, or the like, and is not particularly limited. Further, the shape may be irregular.

When the GaN substrate according to the fourth embodiment is a wafer, the diameter of the GaN substrate is generally 45 mm or more, may be 50 mm or more, may be 95 mm or more, and may be 145 mm or more, in view of nitride semiconductor applications. Typically, the diameter of the GaN substrate is 50 mm to 55 mm (about 2 inches), 100 mm to 105 mm (about 4 inches), 150 mm to 155 mm (about 6 inches), or the like.

In addition, when the GaN crystal has a shape other than the disk shape, a size where the diameter of the disk shape having the same area as the main surface reaches the above size can be adopted.

The preferable thickness of the GaN substrate varies depending on the diameter of the main surface.

When the diameter is about 2 inches, the thickness of the GaN substrate is preferably 250 µm to 450 µm. Here, the above thickness is preferably 250 µm or more, more preferably 300 µm or more, and still more preferably 350 µm or more, and is preferably 450 µm or less, and more preferably 400 µm or less.

When the diameter is about 4 inches, the thickness of the GaN substrate is preferably 350 µm to 750 µm. Here, the above thickness is preferably 350 µm or more, and more preferably 400 µm or more, and is preferably 750 µm or less, more preferably 650 µm or less, and still more preferably 600 µm or less.

When the diameter is about 6 inches, the thickness of the GaN substrate is preferably 450 µm to 800 µm. Here, the above thickness is preferably 450 µm or more, more preferably 550 µm or more, and is preferably 800 µm or less, and more preferably 700 µm or less.

When the GaN substrate is formed of only the Si-doped GaN layer, the thickness of the Si-doped GaN layer is preferably within the above range.

A (000-1) surface 102, which is an N-polar surface of the GaN substrates according to the fourth embodiment, may be mirror-finished as a back surface, or may be rough-finished or matte finished.

A (0001) surface 101, which is a Ga-polar plane of the GaN substrate, is used as a front surface, and a nitride semiconductor layer is further epitaxially grown on the front surface and used for a nitride semiconductor device.

The (0001) surface 101, which is a Ga-polar plane, may be a surface in an as-grown state in which the crystal remains in growth, and is preferably a surface planarized by processing such as polishing, chemical mechanical polishing (CMP), or etching. Further, the (0001) surface 101 may be a surface formed by cutting, or may be a surface on which only the above flattening is performed without cutting.

The root mean square roughness (RMS) of the (0001) surface 101 of the GaN substrate according to the fourth embodiment measured by an atomic force microscope (AFM) is preferably less than 5 nm, more preferably less than 2 nm, still more preferably less than 1 nm, and may be less than 0.5 nm in a measurement range of 2 µm × 2 µm.

An edge of the GaN substrate according to the fourth embodiment may be chamfered. Even in this case, the value represented by [{(α - β)/α} × 100] (%) regarding the Si concentration is 10% or less.

Further, the GaN substrate can be provided with various markings as necessary, such as orientation flats or notches for indicating an orientation of a crystal, and an index flat for facilitating the identification of a front surface and a back surface.

The semiconductor device using the GaN substrate according to the fourth embodiment is basically a nitride semiconductor device. The nitride semiconductor device is a semiconductor device in which a main portion of a device structure is formed of a nitride semiconductor.

The above nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

The type of the nitride semiconductor device using the GaN substrate according to the fourth embodiment is not limited, and examples thereof include light emitting devices such as a laser diode (LD) and a light emitting diode (LED), and electronic devices such as a rectifier, a bipolar transistor, and a field-effect transistor.

### [Method for Producing GaN substrate (2)]

A method for producing the GaN substrate according to the fourth embodiment is not particularly limited as long as desired characteristics are obtained.

As a result of intensive studies by the present inventors, the present inventors have found that, as one aspect of the above production method, the GaN substrate according to the fourth embodiment can be produced by using a vapor phase growth method in forming the Si-doped GaN layer, setting the off-angle of the base crystal at that time within a specific range, and setting the distance between an ejection nozzle port for GaCl gas as a raw material and a substrate surface in a reactor within a specific range.

Therefore, the present invention also relates to a method for producing a Si-doped GaN layer in which the value represented by [{(α - β)/α} × 100] (%) is 10% or less, in which α (atoms/cm³) represents the maximum value of the Si concentration of the surface of the Si-doped GaN layer, and β (atoms/cm³) represents the minimum value thereof.

The method for producing a Si-doped GaN layer is a method for producing a Si-doped GaN layer having a Si concentration of 1 × 10¹⁸ atoms/cm³ or more on a base crystal by a vapor phase growth method. It is characterized in that an off-angle of the base crystal is 0.5° or more, and the distance between a nozzle port for ejecting a gas containing Ga atoms to the base crystal and the surface of the above base crystal is preferably 100 mm or more. Here, the thickness of the above Si-doped GaN layer is preferably 50 µm or more.

That is, an aspect of the method for producing the GaN substrate described in the above [GaN substrate (2)] includes the method for producing the Si-doped GaN layer as one step.

The base crystal on which the Si-doped GaN layer is formed is preferably a c-plane GaN substrate seed, and a Si-doped GaN layer, that is, a (0001)-oriented GaN layer doped with Si is grown on a surface of the base crystal by a vapor phase growth method.

FIG. 2 is a view illustrating the off-angle provided in the base crystal used in the method for forming the Si-doped GaN layer, and in FIG. 2 (a), the (0001) surface of the base crystal is obliquely cut out as indicated by a broken line.

FIG. 2 (b) illustrates the base crystal after cutting, and of FIG. 2 (c) is an enlarged view of a part surrounded by a circle.

As shown in FIG. 2 (c), an angle at which the (0001) surface of the base crystal is cut out is referred to as an off-angle θ, and, by cutting, a cut surface is formed in a stepped shape having a step of a thickness of one atom. A terrace width W representing a width of a terrace T varies depending on the off-angle θ during cutting. That is, the smaller the off-angle θ is, the larger the terrace width W is. As compared with FIG. 2 (c), the terrace width W is reduced as the off-angle θ is increased as shown in FIG. 3.

Here, regarding the fact that the terrace width W becomes narrow when the off-angle θ is set to 0.5° or more, specifically, as shown of FIG. 2 (c), the larger the terrace width W is, the longer the time for the Si adatom adsorbed on the surface of the terrace T moving to and reaching a step end E. The step end E has the kink site S which is the necessary growth site for being incorporated into the GaN crystal.

In contrast, as illustrated in FIG. 3, when the off-angle θ of the base crystal is larger than that in the related art, the terrace width W become narrow, and then the time for moving to and reaching the step end E having the kink site S is shortened. As a result, Si atoms easily enter appropriate sites.

In the reactor 21 shown in FIG. 7, when the distance L between a nozzle port of the introduction pipe P₃ through which the gas containing Ga atoms is ejected to the base crystal and the surface of the base crystal is preferably set to 100 mm or more, the gas is more diffused, and as a result, Si atoms are easily incorporated into an appropriate site.

When high doping with Si is performed so that the Si concentration on the Si-doped GaN layer is as high as 1 × 10¹⁸ atoms/cm³ or more, the uniformity of the Si concentration of the surface of the Si-doped GaN layer is reduced in the related art. However, when the off-angle θ is set to 0.5° or more, and further the distance L between the nozzle port of the introduction pipe P₃ through which the gas containing Ga atoms is ejected to the base crystal and the surface of the base crystal is preferably set to 100 mm or more, the Si concentration of the end portion of the substrate can also be made as high as that in the vicinity of the center of the substrate, and the resistance reduction corresponding to the concentration of doped Si can be uniformly achieved in the entire substrate.

Therefore, in order to obtain the Si-doped GaN layer in the fourth embodiment, the off-angle of the base crystal is preferably 0.5° to 1°. Here, the above off-angle is preferably 0.5° or more, more preferably 0.55° or more, and still more preferably 0.6° or more. On the other hand, from the viewpoint of preventing bunching and maintaining the plane orientation characteristics of the C plane, the off-angle is preferably 1° or less, more preferably 0.9° or less, and still more preferably 0.8° or less.

The distance L between the nozzle port of the introduction pipe P₃ through which the gas containing Ga atoms is ejected to the base crystal and the surface of the base crystal is preferably 100 mm to 300 mm. Here, the above distance L is preferably 100 mm or more, more preferably 110 mm or more, and still more preferably 120 mm or more. On the other hand, from the viewpoint of maintaining the growth rate, the distance L is preferably 300 mm or less, more preferably 250 mm or less, and still more preferably 200 mm or less.

From the viewpoint of further increasing the uniformity of the Si concentration, it is preferable that nozzle ports of the introduction pipe P₁ through which the gas containing N atoms is ejected to the base crystal and the dopant introduction pipe P₄ are disposed on the same horizontal line as that of the nozzle port of the above introduction pipe P₃. That is, the distance L from the nozzle ports of the introduction pipe P₁ and the introduction pipe P₄ to the surface of the base crystal is preferably equal to the distance L between the nozzle port of the introduction pipe P₃ and the surface of the base crystal. In this case, the uniformity of the Si concentration can be further increased.

The GaN substrate having the Si-doped GaN layer according to the fourth embodiment can be obtained by adopting a common production method for other factors besides the off-angle of the base crystal and the above distance L.

For example, a seed wafer 1 was prepared as shown in FIG. 4 (a), and a (0001)-oriented first thick GaN film 2 made of GaN that is not intentionally doped is grown on the seed wafer 1 by the HVPE method as shown in FIG. 4 (b). Further, as shown in FIG. 4 (c), the first thick GaN film 2 may be processed as necessary to obtain a plurality of first c-plane GaN wafers 3.

An example of the seed wafer 1 is a c-plane sapphire wafer, and the seed wafer 1 is preferably provided with a release layer on a main surface thereof. When the release layer is provided, a GaN layer having a thickness of several hundreds of nanometers is grown on a c-plane sapphire wafer via a low-temperature buffer layer by a metalorganic vapor phase epitaxy (MOVPE) method, and a Ti (titanium) layer having a thickness of several tens of nanometers is formed on the above GaN layer by vacuum deposition. Thereafter, the release layer can be formed by, for example, annealing at 1060°C for 30 minutes in a mixed gas atmosphere of 80% H₂ (hydrogen) and 20% NH₃ (ammonia).

It is preferable that the first GaN thick film 2 is preferably thick enough to form the free-standing first c-plane GaN wafer 3, and it is preferable that the first GaN thick film 2 is grown to a thickness of, for example, several millimeters or more to obtain two or more first c-plane GaN wafers 3 therefrom.

On the (0001) crystal plane of the Ga-polar plane of the first c-plane GaN wafer 3 obtained above as shown in FIG. 5 (a), a (0001)-oriented second thick GaN film 4 made of GaN that is not intentionally doped is grown by the HVPE method as shown in FIG. 5 (b). Then, as shown in FIG. 5 (c), the second thick GaN film 4 may be processed as necessary to obtain a plurality of second c-plane GaN wafers 5.

The second c-plane GaN wafer 5 obtained as described above serves as a base crystal when the Si-doped GaN layer is formed, but may be appropriately subjected to planarization processing using techniques such as grinding, polishing, or CMP as desired before obliquely cutting the (0001) crystal plane of the Ga-polar plane. After the planarization, surface roughening using etching may be performed.

A common method can be applied to the planarization processing and the surface roughening processing.

As described above, the off-angle, which is an inclination angle when obliquely cutting out the (0001) crystal plane of the Ga-polar plane, is preferably 0.5° or more. The off-cut direction, which is an inclination direction, is preferably a m-axis direction or an a-axis direction.

The (0001) crystal plane of the GaN crystal layer can be cut using a wire slicing device or a laser slicing device.

A Si-doped GaN layer 6a is formed on the (0001) crystal plane of the second c-plane GaN wafer 5 whose surface is cut out as shown in FIG. 6 (a). An interposed region 6b having a Si concentration of less than 1 × 10¹⁸ atoms/cm³ may be present between the second c-plane GaN wafer 5 and the Si-doped GaN layer 6a as shown in FIG. 6 (b).

When the above GaN crystal or GaN crystal doped with Si is grown by the HVPE method, for example, an HVPE device 20 shown in FIG. 7 can be used.

An HVPE device 20 illustrated in FIG. 7 includes a hot-wall reactor 21, a gallium reservoir 22 and a susceptor 23 disposed in the reactor 21, and a first heater 24 and a second heater 25 disposed outside the reactor 21. The first heater 24 and the second heater 25 each annularly surround the reactor 21.

The reactor 21 is a quartz tube chamber. The reactor 21 includes a first zone Z1 mainly heated by the first heater 24 and a second zone Z2 mainly heated by the second heater 25. An exhaust pipe P_{E} is connected to an end of the reactor 21 on a second zone Z2 side.

The gallium reservoir 22 disposed in the first zone Z1 is a quartz container having a gas inlet and a gas outlet.

The susceptor 23 disposed in the second zone Z2 is formed of, for example, graphite. A mechanism for rotating the susceptor 23 may be freely provided.

In order to grow GaN by the HVPE device 20, a seed is placed on the susceptor 23, and an inside of the reactor 21 is heated by the first heater 24 and the second heater 25. At the same time, NH₃ (ammonia) diluted with a carrier gas is supplied to the second zone Z2 through an ammonia introduction pipe P₁, and HCl (hydrogen chloride) diluted with a carrier gas is supplied to the gallium reservoir 22 through a hydrogen chloride introduction pipe P₂. HCl reacts with the metallic gallium in the gallium reservoir 22, and the generated GaCl (gallium chloride) is carried to the second zone Z2 through a gallium chloride introduction pipe P₃.

The distance L between the substrate surface and the nozzle port of the gallium chloride introduction pipe P₃ in the second zone Z2 is preferably 100 mm or more as described above. Similarly, the nozzle ports of the ammonia introduction pipe P₁ and the dopant introduction pipe P₄ are preferably disposed on the same horizontal plane as that of the nozzle port of the gallium chloride introduction pipe P₃.

NH₃ reacts with GaCl in the second zone Z2, and the generated GaN is crystallized on the seed placed on the susceptor 23.

When growing GaN is to be intentionally doped, a doping gas diluted with a carrier gas is guided to the second zone Z2 in the reactor 21 through a dopant introduction pipe P₄.

Portions of the ammonia introduction pipe P₁, the hydrogen chloride introduction pipe P₂, the gallium chloride introduction pipe P₃, and the dopant introduction pipe P₄ disposed in the reactor 21 are formed of quartz.

As the carrier gas for diluting each of NH₃, HCl, and the doping gas, H₂ (hydrogen gas), N₂ (nitrogen gas), or a mixed gas of H₂ and N₂ is preferably used.

Preferred conditions for growing GaN using the HVPE device 20 are as follows.

The temperature of the gallium reservoir 22 is, for example, 500°C to 1000°C, and preferably 700°C or higher, and is preferably 900°C or lower.

The temperature of the susceptor 23 is, for example, 900°C to 1100°C, preferably 930°C or higher, and more preferably 950°C or higher, and is preferably 1050°C or lower, and more preferably 1020°C or lower.

The V/III ratio, which is a ratio of a NH₃ partial pressure (V) to the GaCl partial pressure (III) in the reactor 21, is, for example, 1 to 20, preferably 2 or more, and more preferably 3 or more, and is preferably 10 or less.

An excessively small or excessively large V/III ratio causes the morphology of the GaN growth surface to deteriorate. Deterioration in the morphology of the growth surface may cause deterioration in the crystal quality.

The growth rate of GaN can be controlled using a product of NH₃ partial pressure and the GaCl partial pressure in the reactor as a parameter. The above growth rate is, for example, 20 µm/h to 200 µm/h, and when the Si-doped GaN layer is grown, the growth rate is preferably 120 µm/h or less, more preferably 100 µm/h or less, and still more preferably 80 µm/h or less.

An excessively high growth rate causes the surface morphology of growing GaN to deteriorate.

When doping is performed with Si, it is preferable to gradually increase a supply rate of the doping gas to a predetermined value over several minutes or several tens of minutes from the start of the supply in order to prevent deterioration in morphology of the growth surface.

For the same reason, the supply of the doping gas is preferably started at a time point when the GaN layer is grown by at least several micrometers.

The doping gas for doping with Si is preferably SiH₄ (silane), SiH₃Cl (monochlorosilane), SiH₂Cls (dichlorosilane), SiHCl₃ (trichlorosilane), or SiCl₄ (tetrachlorosilane).

The partial pressure of the doping gas for doping with Si is preferably 1 × 10⁻⁶ to 2 × 10⁻⁴ kPa, more preferably 2 × 10⁻⁶ kPa or more, and more preferably 1 × 10⁻⁴ kPa or less.

A molar ratio of H₂ in the carrier gas may affect the impurity concentration of GaN to be grown. Here, the molar ratio of H₂ in the carrier gas is calculated based on the flow rate of each gas species supplied as the carrier gas from outside the reactor into the reactor.

The O concentration of GaN grown by the HVPE method during doping with Si tends to decrease as the molar ratio of H₂ in the carrier gas increases, and can be 2 × 10¹⁶ atoms/cm³ or less, and further 1 × 10¹⁶ atoms/cm³ or less. This is because the surface morphology during growth is improved.

The GaN grown using an HVPE device 10 can contain O at a concentration detectable by SIMS even when the GaN is not intentionally doped with O. The O source is either one or both of quartz (SiO₂) used for a reactor and a pipe in the reactor, and moisture remaining or entering the reactor. In addition to Si from a doping gas, the Si source may be quartz (SiO₂) used for the reactor and the pipe in the reactor.

The components disposed in the reactor 11, including components not shown in FIG. 7, may be those formed of SiC (silicon carbide), SiNx (silicon nitride), BN (boron nitride), alumina, W (tungsten), Mo (molybdenum), or the like, in addition to quartz and carbon. Accordingly, the concentration of each impurity other than Si, O, and H in GaN grown using the HVPE device 10 can be set to 5 × 10¹⁵ atoms/cm³ or less unless intentional doping is performed.

In the method for producing the Si-doped GaN layer of the fourth embodiment, the Ga-polar plane of the produced Si-doped GaN layer may be a surface in an as-grown state in which the crystal remains in growth, and may include a step of planarizing the surface. In the planarization step, a known processing method such as polishing, chemical mechanical polishing (CMP), and etching can be used.

The method for producing the Si-doped GaN layer of the fourth embodiment may include a step of obtaining one or a plurality of free-standing GaN substrates by slicing the Si-doped GaN layer produced on the base crystal. In this case, a thick Si-doped GaN layer is grown to the extent that a free-standing GaN substrate can be obtained.

When a free-standing GaN substrate is obtained by slicing a Si-doped GaN substrate, the plane orientation of the main surface cut out during slicing can be freely adjusted. For example, when the free-standing GaN substrate is sliced from the Ga-polar plane of the Si-doped GaN layer in the as-grown state so as to have a lower off-angle, the GaN substrate having the Si-doped GaN layer whose main surface has a low off-angle can be obtained. The GaN substrates according to the first and second embodiments can also be obtained according to this method. In this case, the off-angle of the main surface of the obtained GaN substrate does not necessarily required to coincide with the off-angle of the main surface of the base crystal used in the production step.

### [Examples]

The present invention will be described in detail below with reference to Examples, but the present invention is not limited thereto.

### [Example 1-1]

### 1. Epitaxial Growth of GaN Crystal

Using a vapor phase growth device equipped with a quartz hot wall reactor, a Si-doped GaN layer doped with Si of a GaN crystal was epitaxially grown on a free-standing GaN seed having a diameter of 62 mm and a thickness of 400 µm according to the HVPE method. The off-cut direction and the off-angle of the free-standing GaN seed were m-axis direction and 0.55°.

In this step, (1) a temperature increase step, (2) a Si-doped GaN layer growth step, and (3) a cooling step described below were sequentially performed.

### (1) Temperature Increase Step

First, a free-standing GaN seed was placed in a reactor.

Next, a reactor temperature was increased from room temperature to 1000°C while supplying ammonia and a carrier gas to the free-standing GaN seed. A mixed gas of hydrogen gas and nitrogen gas was used as a carrier gas.

### (2) Si-doped GaN Layer Growth Step

A mixed gas containing ammonia and gallium chloride as shown in the following growth conditions was supplied as a raw gas while maintaining the reactor temperature at 1000°C, thereby epitaxially growing a Si-doped GaN layer on the free-standing GaN seed to have a thickness of 200 µm.

The growth rate was 50 µm/hr, and the growth conditions were as follows: a reactor pressure of 101 kPa; an ammonia partial pressure of 2.57 kPa; a GaCl partial pressure of 1.23 kPa; a hydrogen gas partial pressure of 51.67 kPa; and a nitrogen gas partial pressure of 45.40 kPa; a HCl gas partial pressure of 0.13 kPa; and dichlorosilane partial pressure of 4.36 × 10⁻⁵ kPa.

The flow rate of dichlorosilane was increased to a predetermined partial pressure over 1 minute. Accordingly, it was confirmed that the dislocation density of the Si-doped GaN layer was almost the same as the dislocation density of the free-standing GaN seed, and new dislocations were not generated at an interface between the free-standing GaN seed and the Si-doped GaN layer.

The gas partial pressure (P_{G}) herein refers to a value obtained by multiplying the reactor pressure (P_{R}) by a ratio (r) of a volume flow rate of the gas to a total volume flow rate of all the gases supplied into the reactor, that is, a value represented by P_{G} = r × P_{R}.

### (3) Cooling Step

After completion of the Si-doped GaN layer growth step described in the above (2), the supply of gallium chloride to the free-standing GaN seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the as-grown GaN crystal taken out from the reactor was a mirror surface over the entire surface and was flat.

### 2. Production of GaN Substrate

The as-grown GaN crystal obtained in the above 1. was subjected to laser coring to obtain a GaN substrate as a circular epitaxial substrate having a diameter of 50.8 mm.

Next, lapping and polishing of the +C plane and the -C plane were sequentially performed to complete a 2-inch c-plane GaN substrate in which the thickness of the Si-doped GaN layer was 100 µm and the thickness of the GaN crystal layer was 300 µm. The off-cut direction and the off-angle of the c-plane GaN substrate were m-axis direction and 0.55°.

### 3. Evaluation of GaN Substrate

### <Observation of Recessed Portions in Surface of Si-Doped GaN Layer>

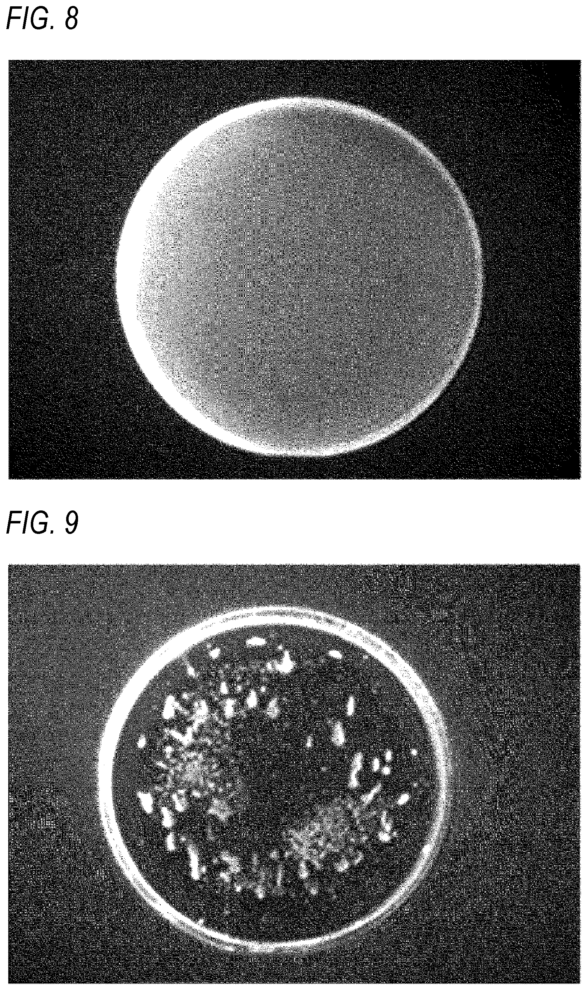

The GaN substrate as the circular epitaxial substrate obtained in the above 2. was irradiated with ultraviolet rays and observed to obtain a fluorescence image. The results are shown in FIG. 8, and no recessed portions with cissing were observed on the surface of the Si-doped GaN layer. That is, on the surface of the Si-doped GaN layer of the GaN substrate, the total of the bottom areas of the recessed defects and the total of the bottom areas of the recessed portions having a depth of 5 µm or more were both 0% of the total area of the surface of the above Si-doped GaN layer. On the surface of the Si-doped GaN layer of the GaN substrate, one or more 25 mm × 25 mm square lattices having no recessed defects were found, and one or more 25 mm × 25 mm square lattices having no recessed portions each having a depth of 5 µm or more were found.

### <Measurement of Si Concentration>

The Si concentration of the Si-doped GaN layer in the c-plane GaN substrate obtained above was measured by SIMS.

As a result, the Si concentration was 7 × 10¹⁸ atoms/cm³.

### [Example 1-2]

The GaN substrate obtained in Example 1-1 was a substrate in which the used GaN crystal layer is a free-standing GaN seed, that is, an undoped GaN seed, and a Si-doped GaN layer is formed thereon. Therefore, it was difficult to accurately measure the carrier concentration by the Hall effect measurement.

Therefore, instead of the free-standing GaN seed in Example 1-1, a semi-insulating GaN seed which is a Mn-doped GaN substrate having a Mn concentration of 1 × 10¹⁸ atoms/cm³ was used, and a Si-doped GaN layer was grown thereon. The Si-doped GaN layer was grown under the same growth conditions as in Example 1-1 except that the growth time was changed so that the thickness was 50 µm.

Here, the specific resistance of the Mn-doped GaN substrate was 1 × 10²⁰ Ωcm or more, and therefore, electricity did not flow through the semi-insulating GaN seed portion during the Hall effect measurement, and it was possible to perform the accurate Hall effect measurement.

The surface of the as-grown GaN crystal taken out from the reactor was a mirror surface over the entire surface and was flat through the cooling step.

### <Observation of Recessed Portions in Surface of Si-Doped GaN Layer>

As a result of obtaining a fluorescence image of the surface of the as-grown GaN crystal in the same manner as in Example 1-1, no recessed portion accompanied by cissing was observed on the surface of the Si-doped GaN layer. That is, on the surface of the Si-doped GaN layer of the GaN substrate, the total of the bottom areas of the recessed defects and the total of the bottom areas of the recessed portions having a depth of 5 µm or more were both 0% of the total area of the surface of the above Si-doped GaN layer. On the surface of the Si-doped GaN layer of the GaN substrate, one or more 25 mm × 25 mm square lattices having no recessed defects were found, and one or more 25 mm × 25 mm square lattices having no recessed portions each having a depth of 5 µm or more were found.

### <Measurement of Si Concentration>

The Si concentration of the Si-doped GaN layer in the c-plane GaN substrate obtained above was measured by SIMS.

As a result, the Si concentration was 7 × 10¹⁸ atoms/cm³.

### <Measurement of Carrier Concentration, Specific Resistance, and Carrier Type>

For the Hall effect measurement, Ti 30 nm and Au 100 nm were continuously vacuum-deposited on a surface of the c-plane GaN substrate obtained as described above. The Hall effect measurement was performed at 300 K by connecting a terminal to the Si-doped GaN layer of the substrate using a four-terminal Van der Pauw method.

As a result, the Si-doped GaN layer had a carrier concentration of 7 × 10¹⁸ atoms/cm³, a specific resistance of 5 × 10⁻³ Ωcm, and an n-type carrier.

From this result, the value represented by {(b/a) × 100} (%), that is, the activation rate was 100%, in which a (atoms/cm³) represents the Si concentration of the Si-doped GaN layer, and b (atoms/cm³) represents the carrier concentration of the Si-doped GaN layer.

### [Example 1-3]

An as-grown GaN crystal was obtained in the same manner as in Example 1-2 except that the dichlorosilane partial pressure was changed to 6.16 × 10⁻⁵ kPa in the growth conditions in the Si-doped GaN layer growth step. The surface of the as-grown GaN crystal taken out from the reactor was a mirror surface over the entire surface and was flat through the cooling step.

### <Observation of Recessed Portions in Surface of Si-Doped GaN Layer>

As a result of obtaining a fluorescence image of the surface of the as-grown GaN crystal in the same manner as in Example 1-1, no recessed portion accompanied by cissing was observed on the surface of the Si-doped GaN layer. That is, on the surface of the Si-doped GaN layer of the GaN substrate, the total of the bottom areas of the recessed defects and the total of the bottom areas of the recessed portions having a depth of 5 µm or more were both 0% of the total area of the surface of the above Si-doped GaN layer. On the surface of the Si-doped GaN layer of the GaN substrate, one or more 25 mm × 25 mm square lattices having no recessed defects were found, and one or more 25 mm × 25 mm square lattices having no recessed portions each having a depth of 5 µm or more were found.

### <Measurement of Si Concentration>

The Si concentration of the Si-doped GaN layer in the c-plane GaN substrate obtained above was measured by SIMS.

As a result, the Si concentration was 9 × 10¹⁸ atoms/cm³.

### <Measurement of Carrier Concentration, Specific Resistance, and Carrier Type>

The Hall effect measurement was performed at 300 K in the same manner as in Example 1-2.

As a result, the Si-doped GaN layer had a carrier concentration of 9 × 10¹⁸ atoms/cm³, a specific resistance of 3.5 × 10⁻³ Ωcm, an n-type carrier, and an activation rate of 100%.

### [Comparative Example 1-1]

An as-grown GaN crystal was obtained by growing a Si-doped GaN layer in the same method as in Example 1-1, except that the off-cut direction and the off-angle of the free-standing GaN seed were set to the m-axis direction and 0.35°.

A fluorescence image of the surface of the as-grown GaN crystal was obtained in the same manner as in Example 1-1. The fluorescence image is shown in FIG. 9, and recessed portions accompanied by cissing were observed on the surface of the Si-doped GaN layer. The depth of the recessed portion serving as the recessed defect was about 200 µm, which was almost equal to the growth thickness of the Si-doped GaN layer. Further, with respect to the area of the entire surface of the Si-doped GaN layer, the total of bottom areas of the recessed portions each having a depth of 5 µm or more was 16%, and the total of the bottom areas of the recessed defects was 16% or more.

### [Comparative Example 1-2]

An as-grown GaN crystal was obtained by growing a Si-doped GaN layer in the same method as in Example 1-1, except that the off-cut direction and the off-angle of the free-standing GaN seed were set to the a-axis direction and 0.40°.

A fluorescence image of the surface of the as-grown GaN crystal was obtained in the same manner as in Example 1-1. As a result, recessed portions accompanied by cissing were observed on the surface of the Si-doped GaN layer. The depth of the recessed portion serving as the recessed defect was about 200 µm, which was almost equal to the growth thickness of the Si-doped GaN layer. Further, with respect to the area of the entire surface of the Si-doped GaN layer, the total of the bottom areas of the recessed portions each having a depth of 5 µm or more was more than 16%, and the total of the bottom areas of the recessed defects was more than 16%.

### [Reference Example 1-1]

A c-plane GaN substrate having a diameter of 50.8 mm was obtained in the same method as in Example 1-1, except that the Si-doped GaN layer on the free-standing GaN seed was epitaxially grown to a thickness of 5 mm to obtain an as-grown GaN crystal, and the obtained as-grown GaN crystal was sliced with a wire saw and then subjected to laser coring and surface polishing in Example 1-1. The off-cut direction and the off-angle of the c-plane GaN substrate were the m-axis direction and 0.35°.

### <Measurement of Carrier Concentration, Specific Resistance, and Carrier Type>

The Hall effect measurement was performed at 300 K in the same manner as in Example 1-2.

As a result, the Si-doped GaN layer had a carrier concentration of 5 × 10¹⁸ atoms/cm³, a specific resistance of 4.9 × 10⁻³ Ωcm, and an n-type carrier.

### As suggested by the present reference example, it was possible to obtain a c-plane GaN substrate having an off-angle which was different from the off-angle of the free-standing GaN seed by modifying the crystal growth conditions and processing conditions of Example 1-1.

### [Example 2-1]

### 1. Epitaxial Growth of GaN Crystal

Using a vapor phase growth device equipped with a quartz hot wall reactor, a Si-doped GaN layer doped with Si of a GaN crystal was epitaxially grown on a free-standing GaN seed having a diameter of 62 mm and a thickness of 400 µm according to the HVPE method. The off-cut direction and the off-angle of the free-standing GaN seed were m-axis direction and 0.55°. The distance L between the GaCl gas ejection nozzle port and the surface of the free-standing GaN seed was set to 150 mm. The ammonia gas ejection nozzle port and the dopant gas ejection nozzle port were disposed on the same horizontal plane. That is, the distance L between from the ammonia gas ejection nozzle port and the dopant gas ejection nozzle port to the surface of the free-standing GaN seed was also set to 150 mm.

In this step, (1) a temperature increase step, (2) a Si-doped GaN layer growth step, and (3) a cooling step described below were sequentially performed.

### (1) Temperature Increase Step

First, a free-standing GaN seed was placed in a reactor.

Next, a reactor temperature was increased from room temperature to 1000°C while supplying ammonia and a carrier gas to the free-standing GaN seed. A mixed gas of hydrogen gas and nitrogen gas was used as a carrier gas.

### (2) Si-doped GaN Layer Growth Step

A mixed gas containing ammonia and gallium chloride as shown in the following growth conditions was supplied as a raw gas while maintaining the reactor temperature at 1000°C, thereby epitaxially growing a Si-doped GaN layer on the free-standing GaN seed to have a thickness of 200 µm.

The growth rate was 50 µm/hr, and the growth conditions were as follows: a reactor pressure of 101 kPa; an ammonia partial pressure of 2.57 kPa; a GaCl partial pressure of 1.23 kPa; a hydrogen gas partial pressure of 51.67 kPa; and a nitrogen gas partial pressure of 45.40 kPa; a HCl partial gas pressure of 0.13 kPa; and dichlorosilane partial pressure of 4.36 × 10⁻⁵ kPa.

The flow rate of dichlorosilane was increased to a predetermined partial pressure over 1 minute. Accordingly, it was confirmed that the dislocation density of the Si-doped GaN layer was substantially the same as the dislocation density of the free-standing GaN seed, and new dislocations were not generated at an interface between the free-standing GaN seed and the Si-doped GaN layer.

The gas partial pressure (P_{G}) herein refers to a value obtained by multiplying the reactor pressure (P_{R}) by a ratio (r) of a volume flow rate of the gas to a total volume flow rate of all the gases supplied into the reactor, that is, a value represented by P_{G} = r × P_{R}.

### (3) Cooling Step

After completion of the Si-doped GaN layer growth step described in the above (2), the supply of gallium chloride to the free-standing GaN seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the as-grown GaN crystal taken out from the reactor was a mirror surface over the entire surface and was flat.

### 2. Production of GaN Substrate

The as-grown GaN crystal obtained in the above 1. was subjected to laser coring to obtain a GaN substrate as a circular epitaxial substrate having a diameter of 50.8 mm.

Next, lapping and polishing of the +C plane and the -C plane were sequentially performed to complete a 2-inch c-plane GaN substrate in which the thickness of the Si-doped GaN layer was 100 µm and the thickness of the GaN crystal layer was 300 µm.

### 3. Evaluation of GaN Substrate

### <Measurement of Si Concentration>

The Si concentration of the Si-doped GaN layer in the c-plane GaN substrate obtained above was measured by SIMS.

As a result, the Si concentration of the center portion on the surface of the Si-doped GaN layer was 7.5 × 10¹⁸ atoms/cm³.

The in-plane distribution of the Si concentration on the surface of the Si-doped GaN layer of the c-plane GaN substrate was measured. Specifically, the Si concentrations were measured at three positions on the surface of the Si-doped GaN layer, including a center portion, a position of 12.5 mm from the center, and a position of 25 mm from the center, that is, an end portion, and the maximum value α of the Si concentration was observed at the center portion, and the value was 7.5 × 10¹⁸ atoms/cm³. The minimum value β of the Si concentration was observed at the end portion, and the value was 7.4 × 10¹⁸ atoms/cm³. As a result, the value represented by [{(α - β)/α} × 100] (%) was 1.3%, indicating that the Si concentrations were uniform over the entire surface of the Si-doped GaN layer, and suggesting that the resistance reduction corresponding to the Si concentration could be achieved uniformly over the entire surface of the GaN substrate.

### [Reference Example 2-1]

The GaN substrate obtained in Example 2-1 is a substrate in which the GaN crystal layer used is a free-standing GaN seed, that is, an undoped GaN seed, and a Si-doped GaN layer is formed thereon. Therefore, it was difficult to accurately measure the carrier concentration by the Hall effect measurement.

Therefore, instead of the free-standing GaN seed in Example 2-1, a semi-insulating GaN seed which is a Mn-doped GaN substrate having a Mn concentration of 1 × 10¹⁸ atoms/cm³ was used, and a Si-doped GaN layer was grown thereon. The Si-doped GaN layer was grown under the same growth conditions as in Example 2-1 except that the growth time was changed so that the thickness was 50 µm.

Here, the specific resistance of the Mn-doped GaN substrate was 1 × 10²⁰ Ωcm or more, and therefore, electricity did not flow through the semi-insulating GaN seed portion during the Hall effect measurement, and it was possible to perform the accurate Hall effect measurement.

The surface of the as-grown GaN crystal taken out from the reactor was a mirror surface over the entire surface and was flat through the cooling step.

### <Measurement of Si Concentration>

The Si concentration of the Si-doped GaN layer in the c-plane GaN substrate obtained above was measured by SIMS.

As a result, the Si concentration of the center portion of the surface of the Si-doped GaN layer was 7 × 10¹⁸ atoms/cm³.

### <Measurement of Carrier Concentration, Specific Resistance, and Carrier Type>

For the Hall effect measurement, Ti 30 nm and Au 100 nm were continuously vacuum-deposited on a surface of the c-plane GaN substrate obtained as described above. The Hall effect measurement was performed at 300 K by connecting a terminal to the Si-doped GaN layer of the substrate using a four-terminal Van der Pauw method.

As a result, the Si-doped GaN layer had a carrier concentration of 7 × 10¹⁸ atoms/cm³, a specific resistance of 5 × 10⁻³ Ωcm, and an n-type carrier.

From this result, the value represented by {(b/a) × 100} (%), that is, the activation rate was 100%, in which a (atoms/cm³) represents the Si concentration of the Si-doped GaN layer, and b (atoms/cm³) represents the carrier concentration of the Si-doped GaN layer.

### [Comparative Example 2-1]

An as-grown GaN crystal was obtained by growing a Si-doped GaN layer in the same method as in Example 2-1, except that the off-cut direction and the off-angle of the free-standing GaN seed were set to the m-axis direction and 0.35° and the distance from the surface of the free-standing GaN seed to each of the GaCl gas ejection nozzle port, the ammonia gas ejection nozzle port and the dopant gas ejection nozzle port was set to 100 mm.

A GaN substrate as a circular epitaxial substrate having a diameter of 50.8 mm was obtained in the same manner as in Example 2-1. Then, the in-plane distribution of the Si concentration on the surface of the Si-doped GaN layer of the c-plane GaN substrate was measured. Specifically, the Si concentrations were measured at three positions on the surface of the Si-doped GaN layer including a center portion, a position of 12.5 mm from the center, and a position of 25 mm from the center, that is, an end portion, and the maximum value α of the Si concentration was observed at the center portion, and the value was 3.9 × 10¹⁸ atoms/cm³. The minimum value β of the Si concentration was observed at the end portion, and the value was 1.6 × 10¹⁸ atoms/cm³. As a result, the value represented by [{(α - β)/α} × 100] (%) was 58%, indicating that the Si concentrations were highly non-uniform over the entire surface of the Si-doped GaN layer as compared with Example 2-1, and suggesting that the resistance reduction corresponding to the Si concentration could not be achieved uniformly over the entire surface of the GaN substrate.

Although the present invention has been described in detail with reference to the specific embodiment, it will be apparent to those skilled in the art that various changes and modifications can be made without departing from the spirit and scope of the present invention. The present application is based on Japanese Patent Application (No. 2022-204832) filed on December 21, 2022, and Japanese Patent Application (No. 2022-204833) filed on December 21, 2022, contents of which are incorporated herein by reference.

### REFERENCE SIGNS LIST

1 seed wafer
2 first thick GaN film
3 first c-plane GaN wafer
4 second thick GaN film
5 second c-plane GaN wafer
6a Si-doped GaN layer
6b interposed region
20 HVPE device
21 reactor
22 gallium reservoir
23 susceptor
24 first heater
25 second heater
100 GaN substrate
101 (0001) surface
102 (000-1) surface
110 Si-doped GaN layer
120 GaN crystal layer

## Claims

1. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a Si concentration of 1 × 10¹⁸ atoms/cm³ or more, and
a total of bottom areas of recessed defects on a surface of the Si-doped GaN layer is 15% or less of an area of the entire surface of the Si-doped GaN layer.

2. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a Si concentration of 1 × 10¹⁸ atoms/cm³ or more, and
a value represented by {(b/a) × 100} (%) is 90% or more, in which a (atoms/cm³) represents a Si concentration of the Si-doped GaN layer, and b (atoms/cm³) represents a carrier concentration of the Si-doped GaN layer.

3. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a Si concentration of 1 × 10¹⁸ atoms/cm³ or more, and
a value represented by [{(α - β)/α} × 100] (%) is 10% or less, in which α (atoms/cm³) represents a maximum value of the Si concentration of a surface of the Si-doped GaN layer, and β (atoms/cm³) represents a minimum value of the Si concentration of a surface of the Si-doped GaN layer.

4. The GaN substrate according to any one of claims 1 to 3, wherein the Si-doped GaN layer has a thickness of 50 µm or more.

5. The GaN substrate according to any one of claims 1 to 3, wherein a total of bottom areas of recessed portions each having a depth of 5 µm or more on the surface of the Si-doped GaN layer is 15% or less of an area of the entire surface of the Si-doped GaN layer.

6. The GaN substrate according to any one of claims 1 to 3, wherein one or more 5 mm × 5 mm square lattices without a recessed defect are present on the surface of the Si-doped GaN layer.

7. The GaN substrate according to any one of claims 1 to 3, wherein one or more 5 mm × 5 mm square lattices without a recessed portion having a depth of 5 µm or more are present on the surface of the Si-doped GaN layer.

8. The GaN substrate according to any one of claims 1 to 3, wherein the Si-doped GaN layer has a specific resistance at 300 K of 1 × 10⁻² Ωcm or less.

9. The GaN substrate according to any one of claims 1 to 3, wherein the Si-doped GaN layer has a specific resistance at 300 K of 8 × 10⁻³ Ωcm or less.

10. The GaN substrate according to any one of claims 1 to 3, wherein the Si-doped GaN layer has a specific resistance at 300 K of 4 × 10⁻³ Ωcm or less.

11. The GaN substrate according to any one of claims 1 to 3, wherein the Si-doped GaN layer has a Si concentration of 5 × 10¹⁸ atoms/cm³ or more.

12. The GaN substrate according to any one of claims 1 to 3, wherein the Si-doped GaN layer has a Si concentration of 9 × 10¹⁸ atoms/cm³ or more.

13. The GaN substrate according to any one of claims 1 to 3, wherein the GaN substrate is a wafer, and the wafer has a diameter of 50 mm or more.

14. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a thickness of 50 µm or more, and
a total of bottom areas of recessed portions each having a depth of 5 µm or more on a surface of the Si-doped GaN layer is 15% or less of an area of the entire surface of the Si-doped GaN layer.

15. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a thickness of 50 µm or more, and
a value represented by {(b/a) × 100} (%) is 90% or more in which a (atoms/cm³) represents a Si concentration of the Si-doped GaN layer, and b (atoms/cm³) represents a carrier concentration of the Si-doped GaN layer.

16. A GaN substrate comprising:
a main surface 1 inclined by 0° to 10° from a (0001) crystal plane which is a Ga-polar plane; and
a Si-doped GaN layer on at least a surface of the main surface 1,
wherein the Si-doped GaN layer has a Si concentration of 1 × 10¹⁸ atoms/cm³ or more,
the Si-doped GaN layer has a thickness of 50 µm or more, and
a value represented by [{(α - β)/α} × 100] (%) is 10% or less, in which α (atoms/cm³) represents a maximum value of the Si concentration of a surface of the Si-doped GaN layer, and β (atoms/cm³) represents a minimum value of the Si concentration of a surface of the Si-doped GaN layer.
